(19) Europäisches Patentamt
European Patent Office
Office européen des brevets

(11) **EP 4 733 981 A1**

(12) **EUROPEAN PATENT APPLICATION**

(43) Date of publication:
**29.04.2026 Bulletin 2026/18**

(21) Application number: **25210318.9**

(22) Date of filing: **22.10.2025**

(51) International Patent Classification (IPC):
**G06G 7/16** *(2006.01)*   **H03M 1/46** *(2006.01)*
**G06N 7/01** *(2023.01)*   **G06G 7/18** *(2006.01)*
**G06N 3/048** *(2023.01)*   **G06N 3/063** *(2023.01)*

(52) Cooperative Patent Classification (CPC):
**G06G 7/16; H03M 1/462;** G06G 7/1806;
G06N 3/048; G06N 3/063; G06N 7/01

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.10.2024 FI 20246267**

(71) Applicant: **Nokia Solutions and Networks Oy
02610 Espoo (FI)**

(72) Inventor: **HAAPALA, Tuomas
Espoo (FI)**

(74) Representative: **Nokia EPO representatives
Nokia Technologies Oy
Karakaari 7
02610 Espoo (FI)**

(54) **RESISTIVE COMPUTE-IN-MEMORY APPARATUS**

(57) Disclosed is an apparatus for computationally intensive applications, such as information technology applications requiring computational power. Disclosed is an apparatus arranged to provide an analog signal to at least one input of an analog compute-in-memory resistive matrix comprised in said apparatus, and to receive a digital signal from at least one direct-drive analog-to-digital converter in the output of said at least one analog compute-in-memory resistive matrix.

Fig. 7

EP 4 733 981 A1

**Description**

TECHNICAL FIELD

The following example embodiments relate to information technology and to computing technologies.

BACKGROUND

Information technology has an ever-growing impact on our society. Modern information technology applications from wireless networks to computer vision and large language models require an increasing amount of computational power. For many computationally intensive applications, the conventional von Neumann architecture can be replaced with more efficient application-specific computational solutions such as ACIM accelerators (ACIM, analog compute-in-memory). ACIM accelerators can be deployed e.g. for computing matrix operations, such as vector-matrix multiplications, VMMs, (VMM, vector-matrix multiplication), or for implementing machine-learning accelerators as stand-alone or jointly with other accelerators such as digital compute-in-memory.

SUMMARY

The scope of protection sought for various example embodiments is set out by the claims. The example embodiments and features, if any, described in this specification that do not fall under the scope of the claims are to be interpreted as examples useful for understanding various embodiments.

According to some aspects, there is provided the subject matter of the independent claims. Some further aspects are defined in the dependent claims.

According to an aspect, there is provided an apparatus comprising: at least one processor; and at least one memory storing instructions that, when executed by the at least one processor, cause the apparatus at least to: provide an analog signal to at least one input of an analog compute-in-memory resistive matrix comprised in said apparatus; receive a digital signal from at least one direct-drive analog-to-digital converter in the output of said at least one analog compute-in-memory resistive matrix.

According to an embodiment, the provided analog signal is converted from a digital signal by at least one direct-drive digital-to-analog converter in the input of said at least one analog compute-in-memory resistive matrix.

According to an embodiment, the at least one analog compute-in-memory resistive matrix is realised with at least one resistive memory comprising at least one resistive element within said at least one resistive memory.

According to an embodiment, the at least one analog compute-in-memory resistive matrix is realised with at least one memory element and at least one resistive element.

According to an embodiment, the at least one direct-drive analog-to-digital converter is direct-drive successive approximation analog-to-digital converter.

According to an embodiment, the at least one direct-drive successive approximation analog-to-digital converter has a self-biasing circuitry comprising a comparator in the input of said direct-drive successive approximation analog-to-digital converter, said comparator arranged to compare a reference node voltage to an input node voltage from an output of an inherent digital-to-analog converter said inherent digital-to-analog converter receiving as an input signal the output signal of said direct-drive successive approximation analog-to-digital converter with inverted polarity.

According to an embodiment, the at least one direct-drive successive approximation analog-to-digital converter is arranged to provide an output signal of said comparator to at least one other digital-to-analog converter via a synchronised successive approximation logic of said at least one direct-drive successive approximation analog-to-digital converter.

According to an embodiment, the at least one direct-drive successive approximation analog-to-digital converter is arranged to provide a logic block output signal to at least one other digital-to-analog converter.

According to an embodiment, the at least one direct-drive successive approximation analog-to-digital converter is arranged to provide said output signal of an inherent digital-to-analog converter to at least one load.

According to an embodiment, the apparatus comprises an activation function between the output of said synchronised successive approximation logic and the input of said inherent digital-to-analog converter or between the output of said synchronised successive approximation logic and the input of said at least one other digital-to-analog converter.

According to an embodiment, in the apparatus a digital output from at least one direct-drive analog-to-digital converter in the output of a first analog compute-in-memory resistive matrix is connected to a digital input to at least one direct-drive digital-to-analog converter in the input of a second analog compute-in-memory resistive matrix.

According to an embodiment, in the apparatus the output columns of a first analog compute-in-memory resistive matrix and the output columns of a second analog compute-in-memory resistive matrix are combined and connected to said at least one direct-drive analog-to-digital converter in the output of said second analog compute-in-memory resistive matrix.

According to an embodiment, in the apparatus the output of an inherent digital-to-analog converter of said at least one direct-drive successive approximation analog-to-digital converter is connected back to the input rows of said at least one analog compute-in-memory resistive matrix for a matrix inverse calculation.

According to an embodiment, in the apparatus the output of an inherent digital-to-analog converter of said at least one direct-drive successive approximation analog-to-digital converter is connected back to the input rows of said at least one analog compute-in-memory resistive matrix via at least one comparator for an Ising machine calculation.

According to an embodiment, the apparatus is an electronic device, a user apparatus, a user device, a node element, a base station, an access network component, a served apparatus, a downlink apparatus, a mobile apparatus, a terminal device, a communication device, a user equipment, a subscriber station, a portable subscriber station, a mobile station, or an access terminal.

According to an aspect, there is provided a non-transitory computer readable medium comprising program instructions which, when executed by an apparatus, cause the apparatus to perform at least the following: provide an analog signal to at least one input of an analog compute-in-memory resistive matrix comprised in said apparatus; receive a digital signal from at least one direct-drive analog-to-digital converter in the output of said at least one analog compute-in-memory resistive matrix.

According to an aspect, there is provided an user apparatus/user device comprising: at least one processor; and at least one memory storing instructions that, when executed by the at least one processor, cause the apparatus at least to: provide an analog signal to at least one input of an analog compute-in-memory resistive matrix comprised in said apparatus; receive a digital signal from at least one direct-drive analog-to-digital converter in the output of said at least one analog compute-in-memory resistive matrix.

According to an aspect, there is provided a node element comprising: at least one processor; and at least one memory storing instructions that, when executed by the at least one processor, cause the apparatus at least to: provide an analog signal to at least one input of an analog compute-in-memory resistive matrix comprised in said apparatus; receive a digital signal from at least one direct-drive analog-to-digital converter in the output of said at least one analog compute-in-memory resistive matrix.

According to an aspect, there is provided a base station comprising: at least one processor; and at least one memory storing instructions that, when executed by the at least one processor, cause the apparatus at least to: provide an analog signal to at least one input of an analog compute-in-memory resistive matrix comprised in said apparatus; receive a digital signal from at least one direct-drive analog-to-digital converter in the output of said at least one analog compute-in-memory resistive matrix.

BRIEF DESCRIPTION OF THE DRAWINGS

In the following, various example embodiments will be described in greater detail with reference to the accompanying drawings, in which

FIG. 1 illustrates an example of an ACIM core based on programmable resistive matrices;
FIG. 2 illustrates an example of an extended ACIM core based on programmable resistive matrices;
FIG. 3 illustrates another example of an extended ACIM core based on programmable resistive matrices;
FIG. 4 illustrates an example of a conventional successive-approximation ADC with a varying input voltage level;
FIG. 5 illustrates an example of a wireless communication network;
FIG. 6 illustrates an example embodiment of a direct-drive successive-approximation analog-to-digital converter;
FIG. 7 illustrates an example embodiment of an ACIM core based on programmable resistive matrices and direct-drive analog-to-digital converters;
FIG. 8 illustrates another example embodiment of an ACIM core based on programmable resistive matrices and direct-drive analog-to-digital converters;
FIG. 9 illustrates an example embodiment of further propagation of the conversion result of a direct-drive successive-approximation analog-to-digital converter;
FIG. 10 illustrates another example embodiment of further propagation of the conversion result of a direct-drive successive-approximation analog-to-digital converter;
FIG. 11 illustrates a third example embodiment of further propagation of the conversion result of a direct-drive successive-approximation analog-to-digital converter;
FIG. 12A illustrates a digital-domain activation function based on a digital rectified linear unit;
FIG. 12B illustrates a digital-domain activation function based on a digital comparator;
FIG. 13 illustrates a fourth example embodiment of further propagation of the conversion result of a direct-drive successive-approximation analog-to-digital converter;

FIG. 14 illustrates an example embodiment of a digital-to-analog converter architecture for resistive analog compute-in-memory cores based on the R-2R topology and its voltage source equivalent;

FIG. 15 illustrates an example embodiment of a 4-bit implementation for programmable resistors in an analog compute-in-memory matrix controlled by a tuning word w;

FIG. 16A illustrates an example embodiment of a signal route analysis of a first column in an analog compute-in-memory matrix core;

FIG. 16B illustrates an equivalent circuit model of an example embodiment of a signal route analysis of a first column in an analog compute-in-memory matrix core;

FIG. 17 illustrates a third example embodiment of an extended ACIM core based on programmable resistive matrices;

FIG. 18 illustrates a fourth example embodiment of an extended ACIM core based on programmable resistive matrices;

FIG. 19 illustrates an example embodiment of a matrix inversion ACIM core based on programmable resistive matrices and direct-drive analog-to-digital converters;

FIG. 20 illustrates an example embodiment of an Ising machine ACIM core based on programmable resistive matrices and direct-drive analog-to-digital converters;

FIG. 21 illustrates an example embodiment of a differential derivative for the single-ended weight unit of a 4-bit implementation for programmable resistors in an analog compute-in-memory matrix;

FIG. 22 illustrates an example embodiment of a hardware implementation for a direct-drive ACIM core supporting negative weights;

FIG. 23 illustrates another example embodiment of a hardware implementation for a direct-drive ACIM core supporting negative weights;

FIG. 24 illustrates a third example embodiment of a hardware implementation for a direct-drive ACIM core supporting negative weights;

FIG. 25 illustrates an example of an apparatus comprising means for performing one or more of the example embodiments described above;

FIG. 26 illustrates an example of an apparatus comprising means for performing one or more of the example embodiments described above;

FIG. 27 illustrates an example of an apparatus according to some embodiments of the present invention in connection with the user apparatus/user device;

FIG. 28 illustrates an example of an apparatus according to some embodiments of the present invention in connection with the node element; and

FIG. 29 illustrates an example of an apparatus according to some embodiments of the present invention in connection with the base station.

## DETAILED DESCRIPTION

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments within the scope of the claims. Furthermore, the words "comprising" and "including" should be understood as not limiting the described embodiments to consist of only those features that have been mentioned, and such embodiments may also contain features that have not been specifically mentioned. Reference numbers, in the description and/or in the claims, serve to illustrate the embodiments with reference to the drawings, without limiting the embodiments to these examples only.

Some example embodiments described herein may be implemented in a wireless communication network comprising a radio access network based on one or more of the following radio access technologies (RATs): global system for mobile communications (GSM) or any other second generation (2G) radio access technology, universal mobile telecommunication system (UMTS, 3G) based on basic wideband-code division multiple access (W-CDMA), high-speed packet access (HSPA), long term evolution (LTE), LTE-Advanced, fourth generation (4G), fifth generation (5G), 5G new radio (NR), 5G-Advanced (i.e., 3GPP NR Rel-18 and beyond), or sixth generation (6G). Some examples of radio access networks include the universal mobile telecommunications system (UMTS) radio access network (UTRAN), the evolved universal terrestrial radio access network (E-UTRA), or the next generation radio access network (NG-RAN). The wireless communication network may further comprise a core network, and some example embodiments may also be applied to network functions of the core network.

It should be noted that the embodiments are not restricted to the wireless communication network given as an example, but a person skilled in the art may also apply the solution to other wireless communication networks or systems provided with necessary properties. For example, some example embodiments may also be applied to a communication system based on IEEE 802.11 specifications, or a communication system based on IEEE 802.15 specifications. IEEE is an abbreviation for the Institute of Electrical and Electronics Engineers.

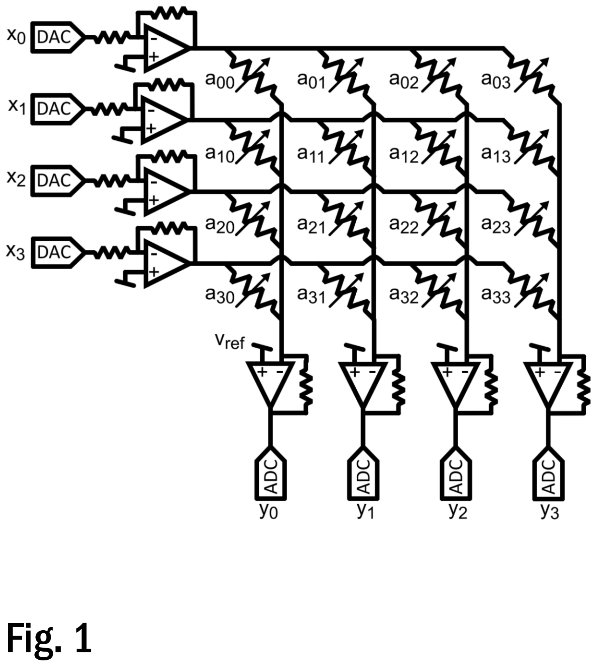

Figure 1 illustrates an example of an ACIM core based on programmable resistive matrices. Analog compute-in-memory accelerators, ACIM accelerators, may be realised based on one or many analog compute-in-memory cores, ACIM cores. A typical method for implementing an ACIM core is based on programmable resistive matrices. The resistive matrix illustrated in the example of Figure 1 implements a vector-matrix multiplication operation, VMM operation, (VMM, vector-matrix multiplication) $y = Ax$ in the analog domain, where x is a vector of input signals, A is a matrix and y is a vector of output signals of the VMM operation, given by Equation 1 as:

$$y = Ax \qquad\qquad (1)$$

$$\begin{bmatrix} y_0 \\ y_1 \\ y_2 \\ y_3 \end{bmatrix} = \begin{bmatrix} a_{00} & a_{10} & a_{20} & a_{30} \\ a_{01} & a_{11} & a_{21} & a_{31} \\ a_{02} & a_{12} & a_{22} & a_{32} \\ a_{03} & a_{13} & a_{23} & a_{33} \end{bmatrix} \begin{bmatrix} x_0 \\ x_1 \\ x_2 \\ x_3 \end{bmatrix} . \qquad\qquad (2)$$

The matrix A depicted in the example of Figure 1 and in Equation 2 is of size 4x4 whereas real ACIM matrices typically grow significantly larger, such as 128x128. Each element $a_{xx}$ in matrix A is typically composed of a programmable resistor $R_u$ or a programmable array of resistors $R_u$. Large resistor $R_u$ resistance is preferred in large ACIM cores to keep the current levels in the matrix manageable. The input vector x may be initially analog or digital.

When input signals are initially digital and the vector of input signals, the input vector x, is initially digital, the input vector x is converted to the analog domain by an array of digital-to-analog converters, DACs, (DAC, digital-to-analog converter) as depicted in the example of Figure 1. The converted analog-domain input signals are then typically buffered by an array of amplifiers as depicted in the example of Figure 1.

The output signals of an ACIM core are also typically buffered by an array of amplifiers as depicted in the example of Figure 1. In addition to buffering, the output amplifiers bias the columns of the matrix to a required reference potential level $v_{ref}$ as depicted in the example of Figure 1. The vector of output signals, the output vector y, of the ACIM core may be utilized in the analog domain or in the digital domain.

When the output vector y of the ACIM core is utilized in the analog domain, it can be directly utilized without conversion. When utilized in the digital domain, the output vector y of the ACIM core must first be converted to digital domain by an array of analog-to-digital converters, ADCs, (ADC, analog-to-digital converter) as depicted in the example of Figure 1.

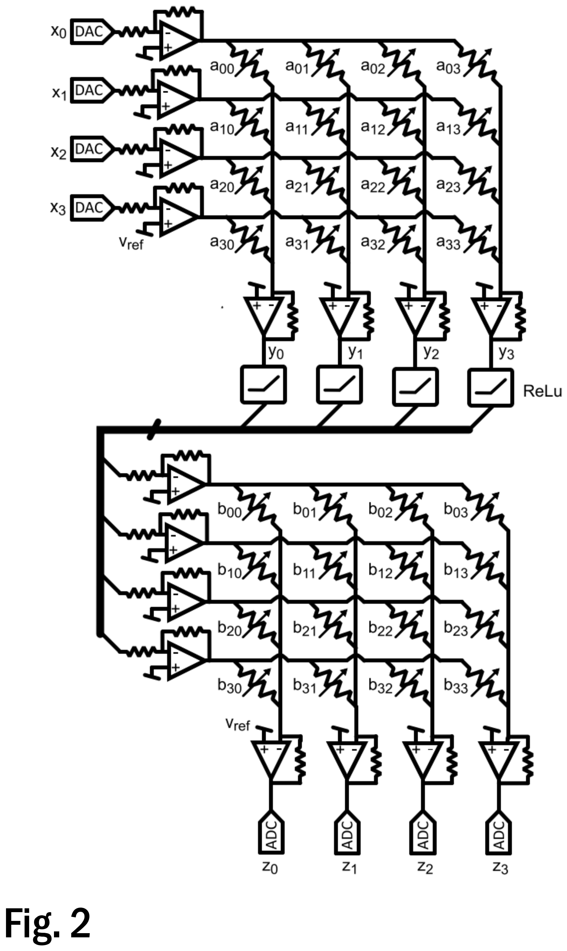

Figure 2 illustrates an example of an extended ACIM core based on programmable resistive matrices. The applicability of an ACIM core can be broadened with different operation modes and extensions. In the example depicted in Figure 2, the applicability of an ACIM core is broadened with an extension where the output vector of one ACIM core is connected to the input of another sequential ACIM core. In machine learning transformers, the output of an ACIM core may be processed with an additional operator before propagation, a common operator being a rectified linear unit, ReLU, (ReLU, rectified linear unit) as depicted in the example of Figure 2.

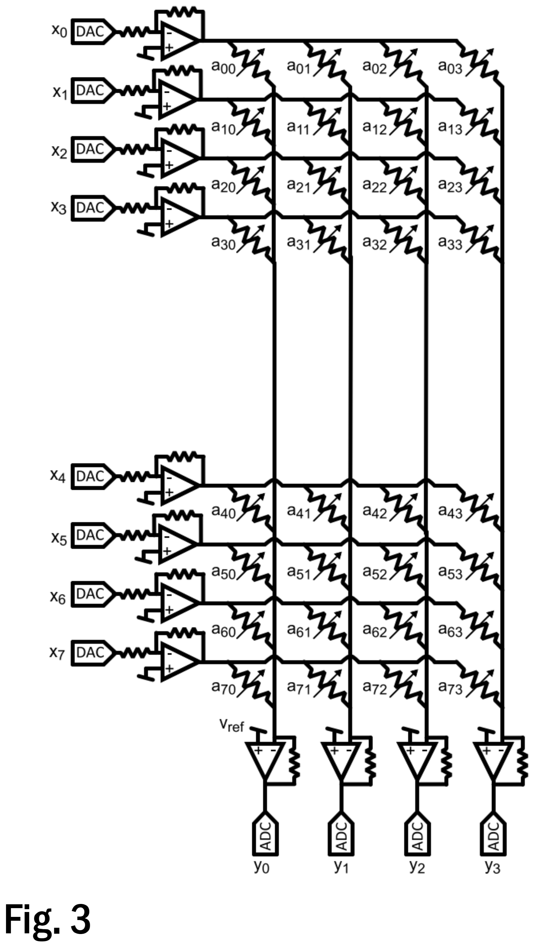

Figure 3 illustrates another example of an extended ACIM core based on programmable resistive matrices. The applicability of an ACIM core can be broadened with different operation modes and extensions. In another example depicted in Figure 3 applicability of an ACIM core is broadened with another extension mode where two ACIM cores have been merged into one effective VMM core whose input vector length is doubled. The different switches and mode control signals required to toggle between different extension modes are omitted in Figure 3 for clarity.

Presently, ACIM cores are typically buffered by analog amplifiers as depicted in Figure 1. Due to the limitations of the amplifier-based approach, the feasible realisation of broadening ACIM cores with different operation modes and extensions still remains limited.

The resistive matrix of an ACIM core is conventionally driven and biased by arrays of operational amplifiers. However, the overhead power, overhead noise, overhead area, limited output voltage swing, and limited bandwidth of these amplifiers often restrict the performance of a resistive ACIM core. The feedback network of an amplifier has a considerable effect on its closed-loop bandwidth and stability, which limits the operation modes, i.e. configurability, of an ACIM core. Consequently, no versatile ACIM cores with multiple operation modes or extensions have been proposed in the literature. Finally, analog signal processing operators and memory suffer from high non-linearity, mismatch and dependence on process, voltage, temperature and aging, PVTA, effects (PVTA, process, voltage, temperature, aging).

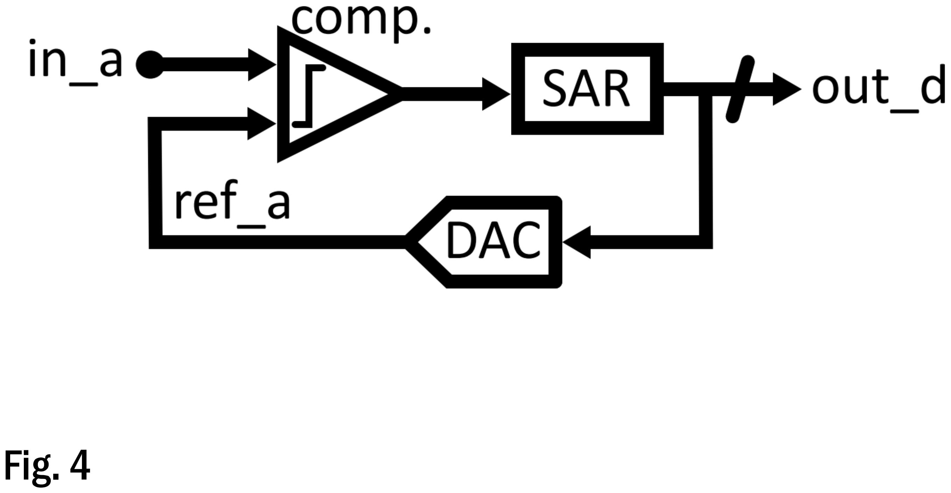

Figure 4 illustrates an example of a conventional successive-approximation ADC with a varying input voltage level. A successive-approximation ADC, SAR ADC, (SAR, successive approximation register) is a type of analog-to-digital converter that converts a continuous analog waveform into a discrete digital representation using successive approximation steps. A discrete-time SAR ADC typically deploys a binary search algorithm. In an example of a successive-approximation ADC depicted in Figure 4 the SAR ADC does not drive its input node and, consequently, it requires a preceding amplifier stage for the correct biasing of the VMM core matrix columns. The input voltage level, i.e. the output of the biasing amplifier, of the conventional SAR ADC successive-approximation ADC depicted in the example of Figure 4 varies.

Computing technologies as well as resistive compute-in-memory apparatuses may be utilized in communications technologies and in wireless technologies.

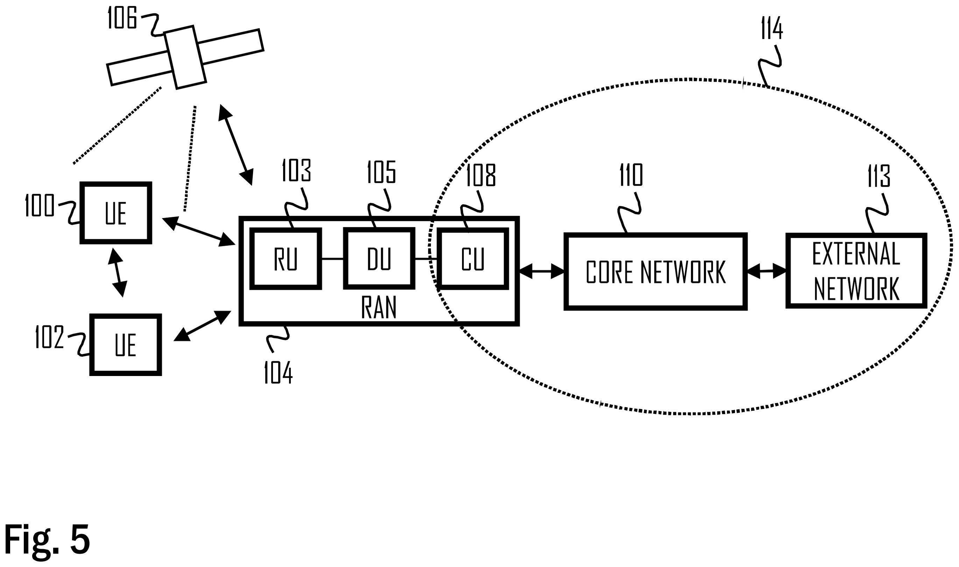

Figure 5 depicts an example of a simplified wireless communication network showing some physical and logical entities. The connections shown in Figure 5 may be physical connections or logical connections. It is apparent to a person skilled in the art that the wireless communication network may also comprise other physical and logical entities than those shown in Figure 5.

The example embodiments described herein are not, however, restricted to the wireless communication network given as an example but a person skilled in the art may apply the example embodiments described herein to other wireless communication networks provided with necessary properties.

The example wireless communication network shown in Figure 5 includes a radio access network (RAN) and a core network 110.

Figure 5 shows user equipment (UE) 100, 102 configured to be in a wireless connection on one or more communication channels in a radio cell with an access node 104 of a radio access network.

The access node 104 may comprise a computing device configured to control the radio resources of the access node 104 and to be in a wireless connection with one or more UEs 100, 102. The access node 104 may also be referred to as a base station, a base transceiver station (BTS), an access point, a cell site, a network node, a radio access network node, or a RAN node. In this description, the terms "access node" and "radio access network node" may be used interchangeably.

The access node 104 may be, for example, an evolved NodeB (abbreviated as eNB or eNodeB), or a next generation evolved NodeB (abbreviated as ng-eNB), or a next generation NodeB (abbreviated as gNB or gNodeB), providing the radio cell. The access node 104 may include or be coupled to transceivers. From the transceivers of the access node 104, a connection may be provided to an antenna unit that establishes a bi-directional radio link to one or more UEs 100, 102. The antenna unit may comprise an antenna or antenna element, or a plurality of antennas or antenna elements.

The wireless connection (e.g., radio link) from a UE 100, 102 to the access node 104 may be called the uplink (UL) or the reverse link, and the wireless connection (e.g., radio link) from the access node 104 to the UE 100, 102 may be called the downlink (DL) or the forward link. A UE 100 may also communicate directly with another UE 102, and vice versa, via a wireless connection generally referred to as a sidelink (SL). It should be appreciated that the access node 104 or its functionalities may be implemented by using any node, host, server, access point or other entity suitable for providing such functionalities.

The radio access network may comprise more than one access node 104, in which case the access nodes may also be configured to communicate with one another over wired or wireless links. These links between access nodes may be used for sending and receiving control plane signaling and also for routing data from one access node to another access node.

The access node 104 may further be connected to a core network (CN) 110. The core network 110 may comprise an evolved packet core (EPC) network and/or a 5$^{th}$ generation core network (5GC). The EPC may comprise network entities, such as a serving gateway (S-GW for routing and forwarding data packets), a packet data network gateway (P-GW) for providing connectivity of UEs to external packet data networks, and/or a mobility management entity (MME). The 5GC may comprise one or more network functions, such as at least one of: a user plane function (UPF), an access and mobility management function (AMF), a location management function (LMF), and/or a session management function (SMF).

The core network 110 may also be able to communicate with one or more external networks 113, such as a public switched telephone network or the Internet, or utilize services provided by them. For example, in 5G wireless communication networks, the UPF of the core network 110 may be configured to communicate with an external data network via an N6 interface. In LTE wireless communication networks, the P-GW of the core network 110 may be configured to communicate with an external data network.

It should also be understood that the distribution of functions between core network operations and access node operations may differ in future wireless communication networks compared to that of the LTE or 5G, or even be non-existent.

The illustrated UE 100, 102 is one type of an apparatus to which resources on the air interface may be allocated and assigned. The UE 100, 102 may also be called a wireless communication device, a subscriber unit, a mobile station, a remote terminal, an access terminal, a user terminal, a terminal device, a mobile phone, a smartphone or a user device, just to mention but a few names. The UE 100, 102 may be a computing device operating with or without a subscriber identification module (SIM), including, but not limited to, the following types of computing devices: a mobile phone, a smartphone, a personal digital assistant (PDA), a handset, a computing device comprising a wireless modem (e.g., an alarm or measurement device, etc.), a laptop computer, a desktop computer, a tablet, a game console, a notebook, a multimedia device, a reduced capability (RedCap) device, a wearable device (e.g., a watch, medical or health device, earphones or eyeglasses) with radio parts, a sensor comprising a wireless modem, or a computing device comprising a wireless modem integrated in a vehicle.

Any feature described herein with a UE may also be implemented with a corresponding apparatus, such as a relay node. An example of such a relay node may be a layer 3 relay (self-backhauling relay) towards the access node. The self-backhauling relay node may also be called an integrated access and backhaul (IAB) node. The IAB node may comprise two logical parts: a mobile termination (MT) part, which takes care of the backhaul link(s) (i.e., link(s) between IAB node and a donor node, also known as a parent node) and a distributed unit (DU) part, which takes care of the access link(s), i.e., child link(s) between the IAB node and UE(s), and/or between the IAB node and other IAB nodes (multi-hop scenario).

Another example of such a relay node may be a layer 1 relay called a repeater. The repeater may amplify a signal received from an access node and forward it to a UE, and/or amplify a signal received from the UE and forward it to the access node.

It should be appreciated that the UE 100, 102 may also be a nearly exclusive uplink-only device, of which an example may be a camera or video camera loading images or video clips to a network. The UE 100, 102 may also be a device having capability to operate in an Internet of Things (IoT) network, which is a scenario in which objects may be provided with the ability to transfer data over a network without requiring human-to-human or human-to-computer interaction.

The wireless communication network may also be able to support the usage of cloud services. For example, at least part of core network operations may be carried out as a cloud service (this is depicted in Figure 5 by "cloud" 114). The UE 100, 102 may also utilize the cloud 114. In some applications, the computation for a given UE may be carried out in the cloud 114 or in another UE.

The wireless communication network may also comprise a central control entity, such as a network management system (NMS), or the like. The NMS is a centralized suite of software and hardware used to monitor, control, and administer the network infrastructure. The NMS is responsible for a wide range of tasks such as fault management, configuration management, security management, performance management, and accounting management. The NMS enables network operators to efficiently manage and optimize network resources, ensuring that the network delivers high performance, reliability, and security.

5G enables using multiple-input and multiple-output (MIMO) antennas in the access node 104 and/or the UE 100, 102, many more base stations or access nodes than an LTE network (a so-called small cell concept), including macro sites operating in co-operation with smaller stations and employing a variety of radio technologies depending on service needs, use cases and/or spectrum available. 5G wireless communication networks may support a wide range of use cases and related applications including video streaming, augmented reality, different ways of data sharing and various forms of machine-type applications, such as (massive) machine-type communications (mMTC), including vehicular safety, different sensors and real-time control.

In 5G wireless communication networks, access nodes and/or UEs may have multiple radio interfaces, such as below 6 gigahertz (GHz), centimeter wave (cmWave) and millimeter wave (mmWave), and also being integrable with legacy radio access technologies, such as LTE. Integration with LTE may be implemented, for example, as a system, where macro coverage may be provided by LTE, and 5G radio interface access may come from small cells by aggregation to LTE. In other words, a 5G wireless communication network may support both inter-RAT operability (such as interoperability between LTE and 5G) and inter-RI operability (inter-radio interface operability, such as between below 6GHz, cmWave, and mmWave).

5G wireless communication networks may also apply network slicing, in which multiple independent and dedicated virtual sub-networks (network instances) may be created within the same physical infrastructure to run services that have different requirements on latency, reliability, throughput and mobility.

5G may enable analytics and knowledge generation to occur at the source of the data. This approach may involve leveraging resources that may not be continuously connected to a network, such as laptops, smartphones, tablets and sensors. Multi-access edge computing (MEC) may provide a distributed computing environment for application and service hosting. It may also have the ability to store and process content in close proximity to cellular subscribers for faster response time. Edge computing may cover a wide range of technologies, such as wireless sensor networks, mobile data acquisition, mobile signature analysis, cooperative distributed peer-to-peer ad hoc networking and processing also classifiable as local cloud/fog computing and grid/mesh computing, dew computing, mobile edge computing, cloudlet, distributed data storage and retrieval, autonomic self-healing networks, remote cloud services, augmented and virtual reality, data caching, Internet of Things (massive connectivity and/or latency critical), critical communications (autonomous vehicles, traffic safety, real-time analytics, time-critical control, healthcare applications).

In one embodiment, an access node 104 may comprise: a radio unit (RU) 103 comprising a radio transceiver (TRX), i.e., a transmitter (Tx) and a receiver (Rx); one or more distributed units (DUs) 105 that may be used for the so-called Layer 1 (L1) processing and real-time Layer 2 (L2) processing; and a central unit (CU) 108 (also known as a centralized unit) that may be used for non-real-time L2 and Layer 3 (L3) processing. The CU 108 may be connected to the one or more DUs 105 for example via an F1 interface. Such an embodiment of the access node 104 may enable the centralization of CUs relative to the cell sites and DUs, whereas DUs may be more distributed and may even remain at cell sites. The CU and DU together may also be referred to as baseband or a baseband unit (BBU). The CU and DU may also be comprised in a radio access point (RAP).

The CU 108 may be a logical node hosting radio resource control (RRC), service data adaptation protocol (SDAP) and/or packet data convergence protocol (PDCP), of the NR protocol stack for an access node 104. The CU 108 may comprise a control plane (CU-CP), which may be a logical node hosting the RRC and the control plane part of the PDCP protocol of the NR protocol stack for the access node 104. The CU 108 may further comprise a user plane (CU-UP), which may be a logical node hosting the user plane part of the PDCP protocol and the SDAP protocol of the CU for the access node 104.

The DU 105 may be a logical node hosting radio link control (RLC), medium access control (MAC) and/or physical (PHY) layers of the NR protocol stack for the access node 104. The operations of the DU 105 may be at least partly controlled by the CU 108. It should also be understood that the distribution of functions between the DU 105 and the CU 108 may vary depending on the implementation.

Cloud computing systems may also be used to provide the CU 108 and/or DU 105. A CU provided by a cloud computing system may be referred to as a virtualized CU (vCU). In addition to the vCU, there may also be a virtualized DU (vDU) provided by a cloud computing system. Furthermore, there may also be a combination, where the DU may be implemented on so-called bare metal solutions, for example application-specific integrated circuit (ASIC) or customer-specific standard product (CSSP) system-on-a-chip (SoC).

Edge cloud may be brought into the radio access network by utilizing network function virtualization (NFV) and software defined networking (SDN). Using edge cloud may mean access node operations to be carried out, at least partly, in a computing system operationally coupled to a remote radio head (RRH) or a radio unit (RU) 103 of an access node 104. It is also possible that access node operations may be performed on a distributed computing system or a cloud computing system located at the access node 104. Application of cloud RAN architecture enables RAN real-time functions being carried out at the radio access network (e.g., in a DU 105), and non-real-time functions being carried out in a centralized manner (e.g., in a CU 108).

5G (or new radio, NR) wireless communication networks may support multiple hierarchies, where multi-access edge computing (MEC) servers may be placed between the core network 110 and the access node 104. It should be appreciated that MEC may be applied in LTE wireless communication networks as well.

A 5G wireless communication network ("5G network") may also comprise a non-terrestrial communication network, such as a satellite communication network, to enhance or complement the coverage of the 5G radio access network. For example, satellite communication may support the transfer of data between the 5G radio access network and the core network 110, enabling more extensive network coverage. Possible use cases may include: providing service continuity for machine-to-machine (M2M) or Internet of Things (IoT) devices or for passengers on board of vehicles, or ensuring service availability for critical communications, and future railway, maritime, or aeronautical communications. Satellite communication may utilize geostationary earth orbit (GEO) satellite systems, but also low earth orbit (LEO) satellite systems, in particular mega-constellations (i.e., systems in which hundreds of (nano)satellites are deployed). A given satellite 106 in the mega-constellation may cover several satellite-enabled network entities that create on-ground cells. The on-ground cells may be created through an on-ground relay access node or by an access node located on-ground or in a satellite.

It is obvious for a person skilled in the art that the access node 104 depicted in Figure 5 is just an example of a part of a radio access network, and in practice the radio access network may comprise a plurality of access nodes 104, the UEs 100, 102 may have access to a plurality of radio cells, and the radio access network may also comprise other apparatuses, such as physical layer relay access nodes or other entities. At least one of the access nodes may be a Home eNodeB or a Home gNodeB. A Home gNodeB or a Home eNodeB is a type of access node that may be used to provide indoor coverage inside a home, office, or other indoor environment.

Additionally, in a geographical area of a radio access network, a plurality of different kinds of radio cells as well as a plurality of radio cells may be provided. Radio cells may be macro cells (or umbrella cells) which may be large cells having a diameter of up to tens of kilometers, or smaller cells such as micro-, femto- or picocells. The access node(s) 104 of Figure 5 may provide any kind of these cells. A cellular radio network may be implemented as a multilayer access networks including several kinds of radio cells. In multilayer access networks, one access node may provide one kind of a radio cell or radio cells, and thus a plurality of access nodes may be needed to provide such a multilayer access network.

For fulfilling the need for improving performance of radio access networks, the concept of "plug-and-play" access nodes may be introduced. A radio access network, which may be able to use "plug-and-play" access nodes, may include, in addition to Home eNodeBs or Home gNodeBs, a Home Node B gateway (HNB-GW) (not shown in Figure 5). An HNB-GW, which may be installed within an operator's radio access network, may aggregate traffic from a large number of Home eNodeBs or Home gNodeBs back to a core network 110 of the operator.

6G wireless communication networks are expected to adopt flexible decentralized and/or distributed computing systems and architecture and ubiquitous computing, with local spectrum licensing, spectrum sharing, infrastructure sharing, and intelligent automated management underpinned by mobile edge computing, artificial intelligence, short-packet communication and blockchain technologies. Key features of 6G may include intelligent connected management and control functions, programmability, integrated sensing and communication, reduction of energy footprint, trustworthy infrastructure, scalability and affordability. In addition to these, 6G is also targeting new use cases covering the integration of localization and sensing capabilities into system definition to unifying user experience across physical and digital worlds.

Some example embodiments are described below using principles and terminology of 5G radio access technology without limiting the example embodiments to 5G radio access technology, however.

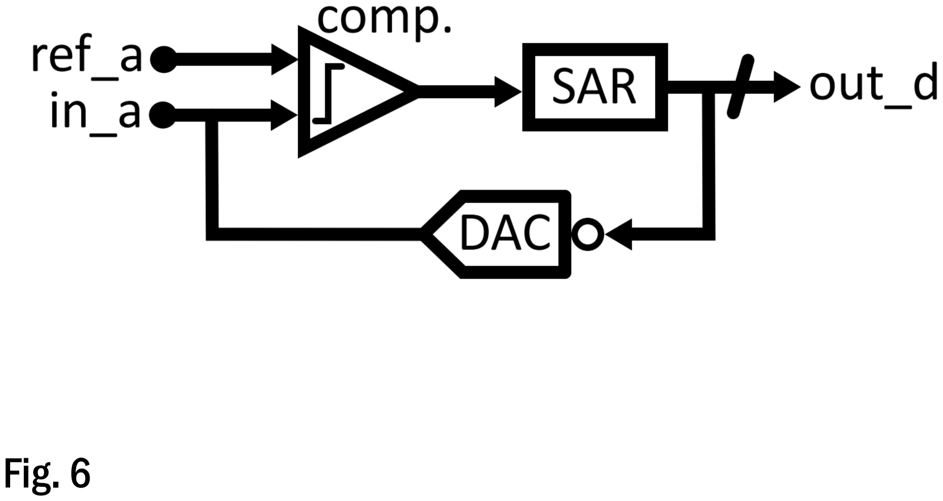

Figure 6 illustrates an example embodiment of a direct-drive successive-approximation analog-to-digital converter. A successive-approximation ADC, SAR ADC, (SAR, successive approximation register) is a type of analog-to-digital converter that converts a continuous analog waveform into a discrete digital representation using successive approximation steps. A discrete-time SAR ADC typically deploys a binary search algorithm while a continuous-time SAR ADC may also deploy a line search algorithm. In an example embodiment of a direct-drive successive-approximation ADC depicted in Figure 6 the SAR ADC drives its input node. Consequently, the direct-drive SAR ADC can self-bias using its inherent digital-to-analog converter, iDAC (iDAC, inherent digital-to-analog converter).

The iDAC does not require a sequential buffer amplifier assuming an ACIM core of large unit resistor $R_u$ resistance. The input voltage level of the direct-drive SAR ADC remains constant, making comparator design considerably easier.

The polarity of the iDAC is inverted in the direct-drive configuration as the direct-drive iDAC attempts to counteract any changes in the input signal level of the SAR ADC. The output of the direct-drive iDAC is connected to the input of the SAR ADC directly, as depicted in Figure 6. In another embodiment, the output of a direct-drive iDAC is connected to the input of the SAR ADC through a feedback network.

In an apparatus comprising an analog compute-in-memory resistive matrix with direct-drive successive-approximation analog-to-digital converters illustrated in the example embodiment of Figure 6, at least one of said direct-drive successive approximation analog-to-digital converters has a self-biasing circuitry comprising a comparator in the input of said direct-drive successive approximation analog-to-digital converter, said comparator arranged to compare a reference node voltage to an input node voltage from an output of an inherent digital-to-analog converter said inherent digital-to-analog converter receiving as an input signal the output signal of said direct-drive successive approximation analog-to-digital converter with inverted polarity.

The use of a direct-drive analog-to-digital converter technology in the example embodiment of an apparatus comprising an analog compute-in-memory resistive matrix enables flexible extensions and reconfigurability for an ACIM core.

In the analog compute-in-memory resistive matrix utilising direct-drive analog-to-digital converter technology the direct-drive ADC is not very sensitive in changes in its feedback network, as long as the time constant of the network is small compared to the clock rate of the ADC. The conversion result of a direct-drive ADC can therefore be propagated further.

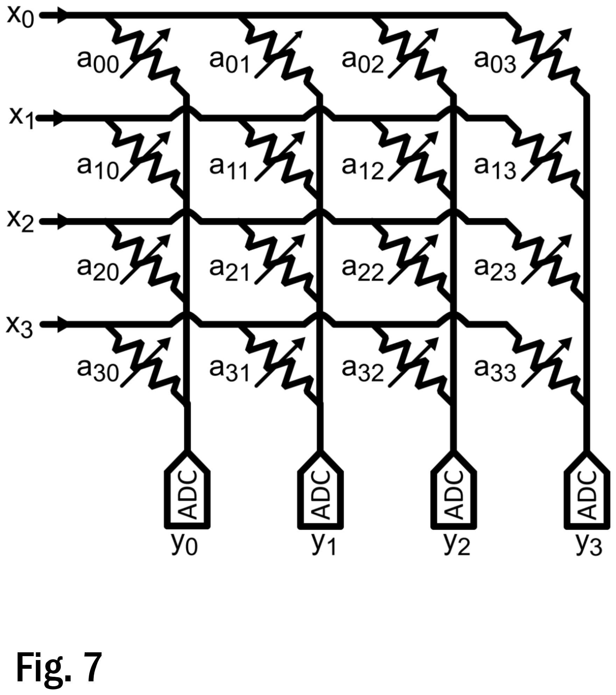

Figure 7 illustrates an example embodiment of an ACIM core based on programmable resistive matrices and direct-drive analog-to-digital converters. The resistive matrix illustrated in the example of Figure 7 implements the same VMM operation y = Ax in the analog domain, where x is a vector, A is a matrix and y is a vector as described in the example of Figure 1 and in Equations 1 and 2.

The matrix A depicted in the example embodiment of Figure 7 and in Equation 2 is of size 4x4 whereas real ACIM matrices typically grow significantly larger, such as, and not limited to, 128x128. Each element $a_{xx}$ in matrix A is typically composed of a programmable resistor $R_u$ or a programmable array of resistors $R_u$. Large resistor $R_u$ resistance is preferred in large ACIM cores to keep the current levels in the matrix manageable. In the resistive matrix illustrated in the example embodiment of Figure 7 the input vector x is analog. The resistive matrix illustrated in the example embodiment of Figure 7 deploys direct-drive ADCs replacing the performance-limiting amplifiers in an ACIM core.

In an apparatus comprising an analog compute-in-memory resistive matrix illustrated in the example embodiment of Figure 7, an analog signal is provided to input of an analog compute-in-memory resistive matrix comprised in said apparatus. As the vector-matrix multiplication operation is implemented in the apparatus a digital signal is received from direct-drive analog-to-digital converters in the output of said analog compute-in-memory resistive matrix.

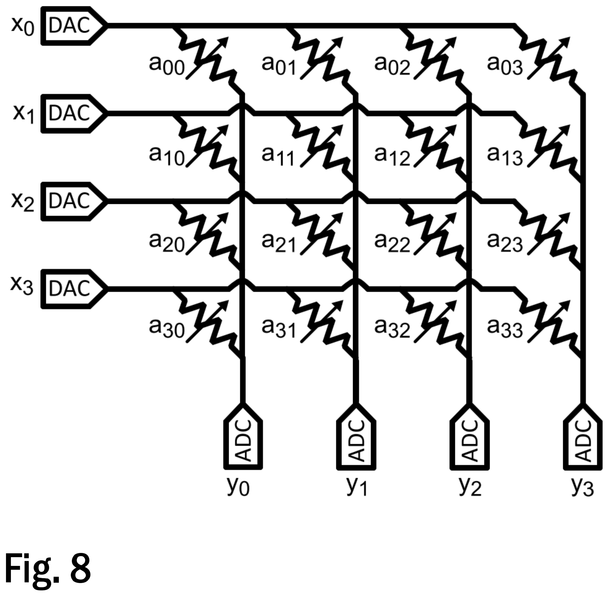

Figure 8 illustrates another example embodiment of an ACIM core based on programmable resistive matrices and direct-drive analog-to-digital converters. The resistive matrix illustrated in the example embodiment of Figure 8 implements the same VMM operation y = Ax in the analog domain, where x is a vector, A is a matrix and y is a vector as described in the example of Figure 1 and Equations 1 and 2. The matrix A depicted in the example embodiment of Figure 8 and in Equation 2 is of size 4x4 whereas real ACIM matrices typically grow significantly larger, such as, and not limited to, 128x128. Each element $a_{xx}$ in matrix A is typically composed of a programmable resistor $R_u$ or a programmable array of resistors $R_u$. Large resistor $R_u$ resistance is preferred in large ACIM cores to keep the current levels in the matrix manageable.

In the resistive matrix illustrated in the example embodiment of Figure 8 the input vector x is digital. The resistive matrix illustrated in the example embodiment of Figure 8 deploys direct-drive DACs and direct-drive ADCs replacing the performance-limiting amplifiers in an ACIM core.

In an apparatus comprising an analog compute-in-memory resistive matrix illustrated in the example embodiment of Figure 8, direct-drive DACs can be deployed without a sequential buffering amplifier in resistive matrices where the unit resistor resistance $R_u$ is large. Due to the large unit resistor $R_u$ resistance, the direct-drive DAC sees a high-impedance resistive load, and its output swing is not critically attenuated despite the omitted buffer. Variable analog gain corresponds to logical shift operations in the digital domain.

In an apparatus comprising an analog compute-in-memory resistive matrix illustrated in the example embodiment of Figure 8, an analog signal is provided to input of an analog compute-in-memory resistive matrix comprised in said apparatus. In the example embodiment of Figure 8, said provided analog signal is converted from a digital signal by direct-drive digital-to-analog converters in the input of said analog compute-in-memory resistive matrix. As the vector-matrix multiplication operation is implemented in the apparatus a digital signal is received from direct-drive analog-to-digital converters in the output of said analog compute-in-memory resistive matrix.

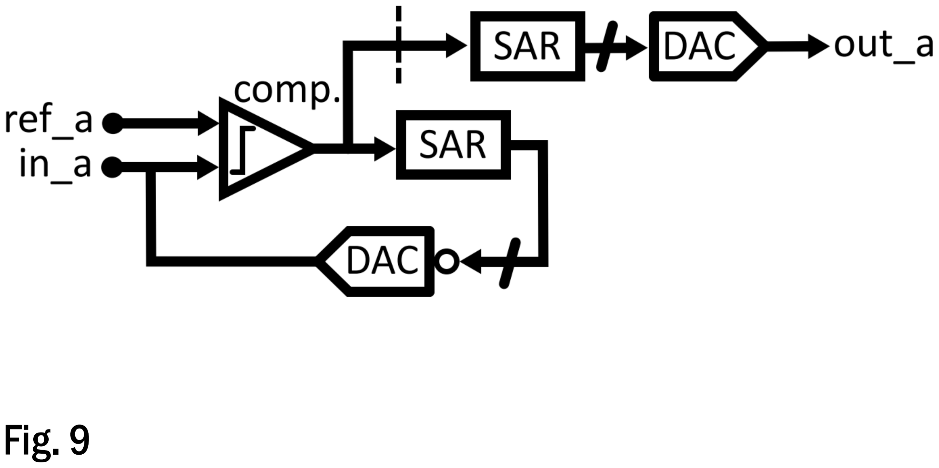

Figure 9 illustrates an example embodiment of further propagation of the conversion result of a direct-drive successive-approximation analog-to-digital converter. In an apparatus comprising an analog compute-in-memory resistive matrix with direct-drive successive-approximation analog-to-digital converters illustrated in the example embodiment of Figure 9, at least one of said direct-drive successive approximation analog-to-digital converters is arranged to provide an output signal of said comparator to at least one other digital-to-analog converter via a synchronised successive approximation logic of said at least one direct-drive successive approximation analog-to-digital converter. Propagation from the comparator output requires only one signal line, making routing easier in dense environments but requiring a parallel synchronized SAR logic block. The dashed line marks a potentially long signal line or a potentially long data bus.

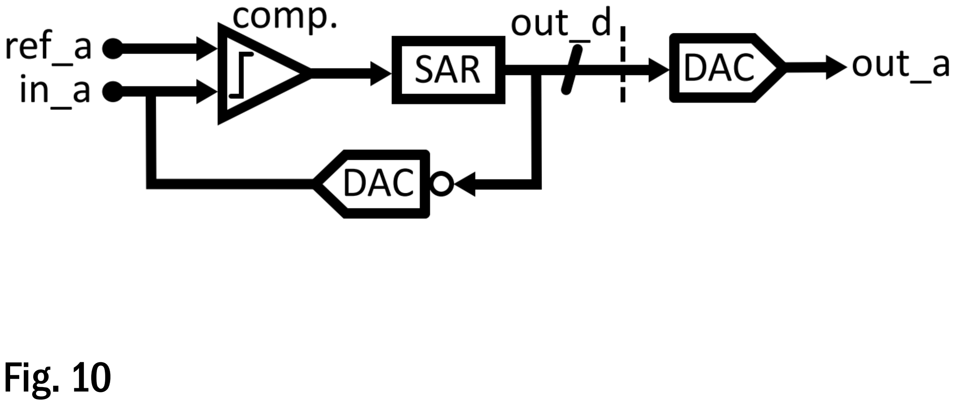

Figure 10 illustrates another example embodiment of further propagation of the conversion result of a direct-drive successive-approximation analog-to-digital converter. In an apparatus comprising an analog compute-in-memory resistive matrix with direct-drive successive-approximation analog-to-digital converters illustrated in the example embodiment of Figure 10, at least one of said direct-drive successive approximation analog-to-digital converters is arranged to provide a logic block output signal to at least one other digital-to-analog converter. Propagation from the SAR logic block output does not require extra hardware resources but necessitates the routing of a full digital bus. The dashed line marks a potentially long signal line or a potentially long data bus.

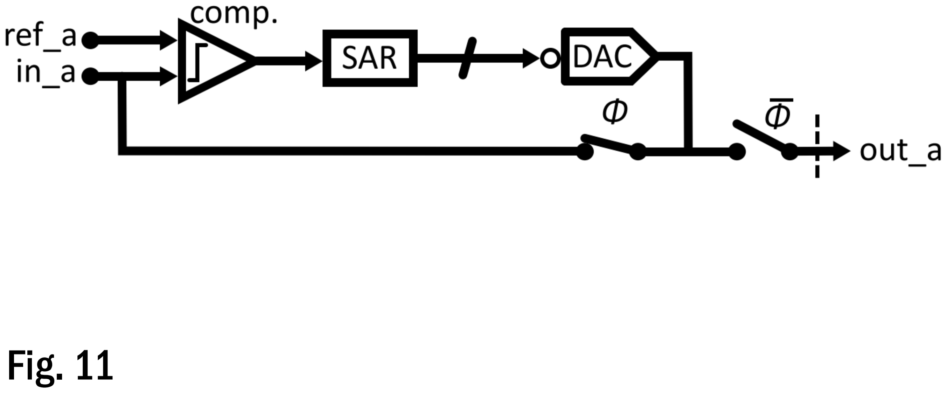

Figure 11 illustrates a third example embodiment of further propagation of the conversion result of a direct-drive successive-approximation analog-to-digital converter. In an apparatus comprising an analog compute-in-memory resistive matrix with direct-drive successive-approximation analog-to-digital converters illustrated in the example embodiment of Figure 11, at least one of said direct-drive said at least one direct-drive successive approximation analog-to-digital converter is arranged to provide said output signal of an inherent digital-to-analog converter to at least one load. Propagation from the output of the digital-to-analog converter does not require extra hardware resources but necessitates some time-domain multiplexing. The dashed line marks a potentially long signal line or a potentially long data bus.

In an embodiment of an apparatus comprising an analog compute-in-memory resistive matrix with direct-drive successive-approximation analog-to-digital converters, said apparatus comprises an activation function between the output of said synchronised successive approximation logic and the input of said inherent digital-to-analog converter or between the output of said synchronised successive approximation logic and the input of said at least one other digital-to-analog converter.

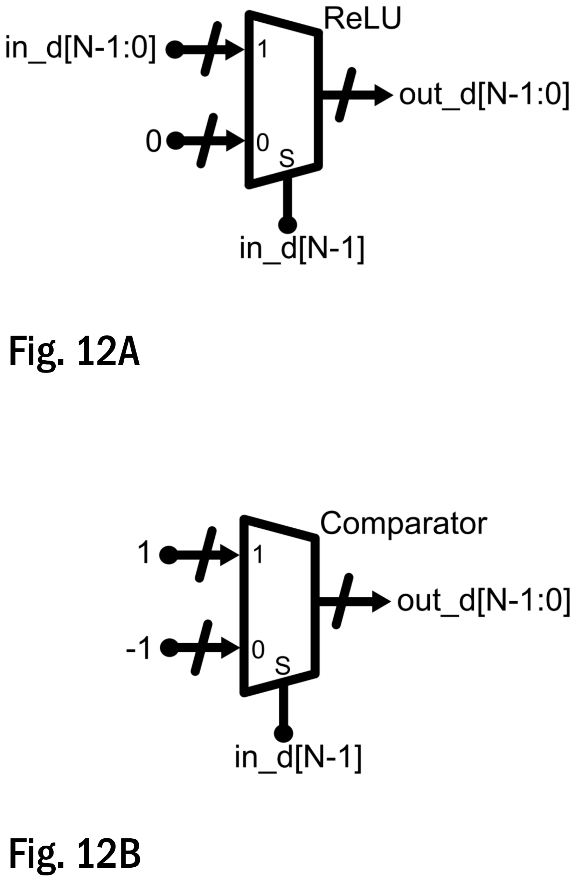

Figure 12A illustrates a digital-domain activation function based on a digital rectified linear unit. In an example embodiment of Figure 12A signal processing operations of a digital rectified linear unit are realized in the digital domain using a simple multiplexer for an N-bit digital word. To implement a digital rectified linear unit, the multiplexer of Figure 12A uses the sign bit in_d[N-1] of its input data to decide on whether to propagate the input data as is or, alternatively, whether to propagate a zero. In an apparatus comprising an analog compute-in-memory resistive matrix with direct-drive successive-approximation analog-to-digital converters, a digital-domain activation function illustrated in the example embodiment of Figure 12A may be deployed in a machine learning accelerator.

Figure 12B illustrates a digital-domain activation function based on a digital comparator. In an example embodiment of Figure 12B signal processing operations of a digital comparator, e.g. level comparison, are realized in the digital domain using a simple multiplexer for an N-bit digital word. To implement a digital comparator, the multiplexer of Figure 12B uses the sign bit of its input data to decide on whether to propagate a positive or a negative number, i.e. the comparison is executed against input data value of zero. In an apparatus comprising an analog compute-in-memory resistive matrix with direct-drive successive-approximation analog-to-digital converters, a digital-domain activation function illustrated in the example embodiment of Figure 12B may be deployed in an Ising machine.

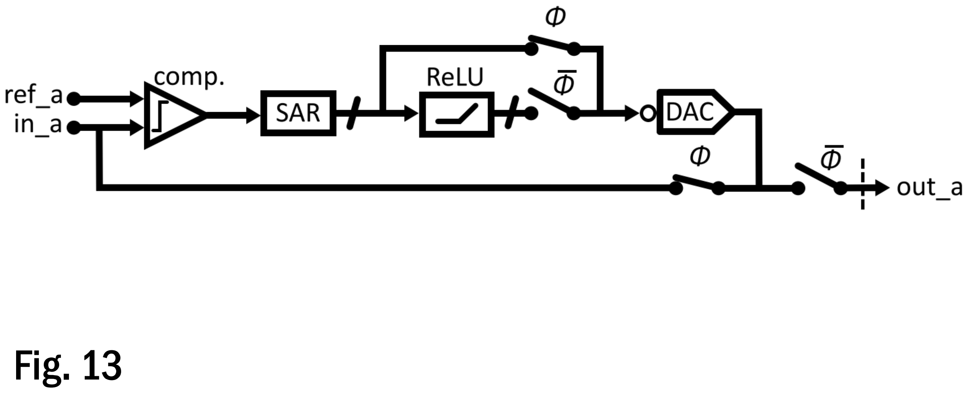

Figure 13 illustrates a fourth example embodiment of further propagation of the conversion result of a direct-drive successive-approximation analog-to-digital converter. In an apparatus comprising an analog compute-in-memory resistive matrix with direct-drive successive-approximation analog-to-digital converters illustrated in the example embodiment of Figure 13, at least one of said direct-drive said at least one direct-drive successive approximation analog-to-digital converter is arranged to provide said output signal of an inherent digital-to-analog converter to at least one load. Propagation from the output of the digital-to-analog converter does not require extra hardware resources but necessitates some time-domain multiplexing. In the example embodiment of Figure 13, a rectified linear unit is added to the example embodiment of Figure 11 between a SAR logic block output and an input of an analog-to-digital converter with inverted polarity. The dashed line marks a potentially long signal line or a potentially long data bus.

In addition to various signal processing operators, non-volatile memory is also easy to implement in the digital domain, whereas analog signal processing operators and memory suffer from leakage, charge injection, high non-linearity, mismatch and dependence on process, voltage, temperature and aging, PVTA, dependence issues (PVTA, process, voltage, temperature, aging).

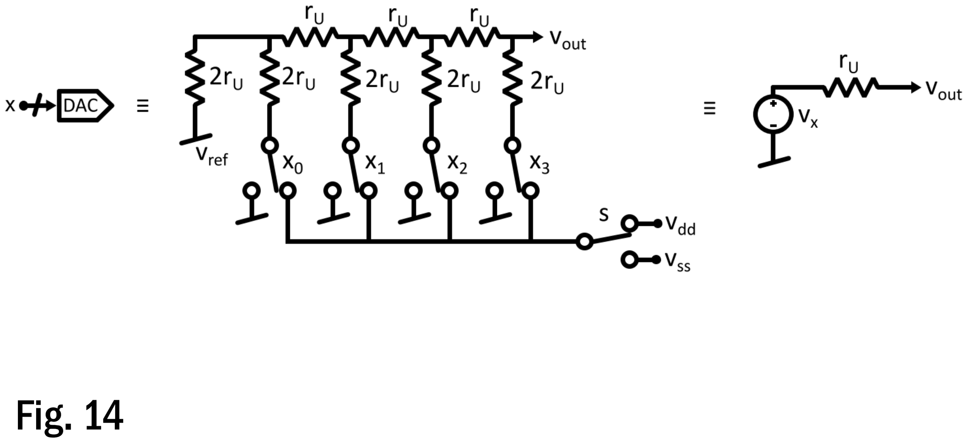

Figure 14 illustrates an example embodiment of a digital-to-analog converter architecture for resistive analog compute-in-memory cores based on the R-2R topology and its voltage source equivalent. A potential digital-to-analog converter architecture for resistive analog compute-in-memory cores is based on the R-2R topology, in which a 4-bit R-2R digital-to-analog converter is shown in Figure 14 with a unit resistance of $r_u$.

The control of the digital-to-analog converter is executed through switch branches controlled by the tuning word x. Bit $x_3$ represents the most significant bit and bit $x_0$ represents the least significant bit. One bias rail of each branch is connected to a reference potential vref while the other rail is connected to one of the supplies of the DAC. The sign bit s of the control word dictates whether connected supply is $v_{dd}$ or $v_{ss}$ potential. In many practical implementations, $v_{ref}$ = $vdd$/2 and $v_{ss}$ = 0 V. However, for convenience, it is here assumed that $v_{ref}$ = 0 $V$ and $v_{ss}$ = - $v_{dd}$. This assumption does not affect the eventual outcome of the analysis. Assuming positive sign control, the corresponding driving voltage $v_x$ of the equivalent voltage source model for our $N_x$-bit digital-to-analog converter is given by Equation 3 as:

$$v_x = \frac{\sum_{k=0}^{N_x-1} 2^k x_k}{2^{N_x}} v_{dd} \ . \tag{3}$$

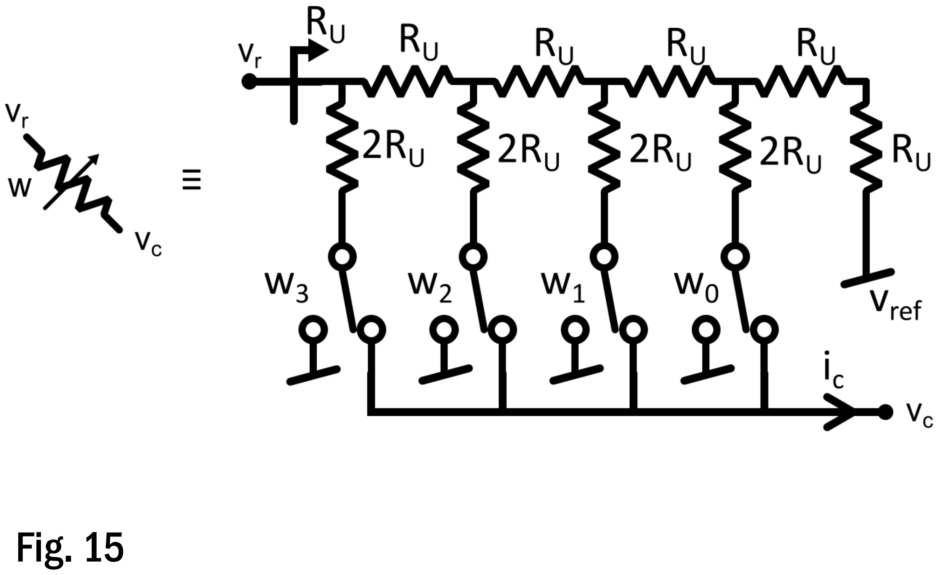

Figure 15 illustrates an example embodiment of a 4-bit implementation for programmable resistors in an analog compute-in-memory matrix controlled by a tuning word w. In the presented example embodiment of a 4-bit implementation for programmable resistors in an analog compute-in-memory matrix, the architecture used in digital-to-analog converter architecture for resistive analog compute-in-memory cores is based on the R-2R topology. In the presented example embodiment, a unit resistor of $R_u$ is used and the programmable R-2R resistor of the R-2R topology is controlled by a tuning word w.

The input $v_r$ of the programmable resistor is in the voltage domain while the output $i_c$ of the programmable resistor is in the current domain. The input voltage of the programmable resistor is set by a direct-drive digital-to-analog converter at the corresponding compute-in-memory matrix row while the output voltage $v_c$ of the programmable resistor is set by the inherent digital-to-analog converter of the direct-drive successive-approximation analog-to-digital converter at the corresponding compute-in-memory matrix column. By default, the output voltage of the programmable resistor is set to the same level as the reference voltage $v_{ref}$. Assuming functional output voltage biasing, the output current $i_C$ of an $N_w$-bit programmable resistor is given by Equation 4 as:

$$i_c = \frac{\sum_{k=0}^{N_w-1} 2^k w_k}{2^{N_w}} \frac{v_r}{R_u} \ . \tag{4}$$

One important feature of the programmable R-2R resistor is that its effective input resistance is always $R_u$ independently of the tuning word.

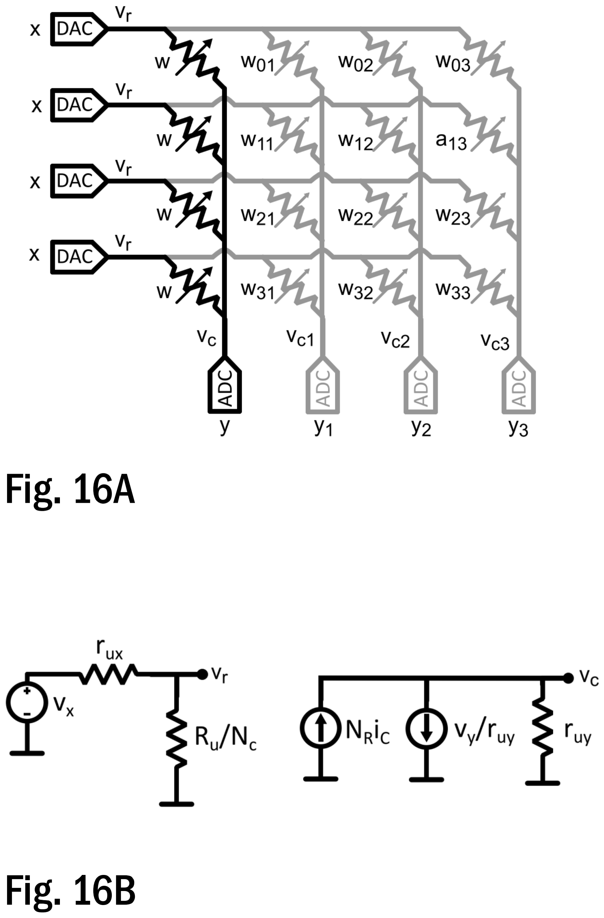

Figure 16A illustrates an example embodiment of a signal route analysis of a first column in an analog compute-in-memory matrix core. In the following analysis, we inspect the first column of ACIM core of Figure 16A where the signal route under analysis is highlighted in black. The size of the shown analog compute-in-memory core is 4x4 for clarity but our analysis assumes a core size of $N_R \times N_C$, where $N_R$ is the number of rows in the analog compute-in-memory core and Nc is the number of columns in the analog compute-in-memory core.

Figure 16B illustrates an equivalent circuit model of an example embodiment of a signal route analysis of a first column in an analog compute-in-memory matrix core.

For simplicity in the following analysis, we assume that all input digital-to-analog converters are controlled identically. Additionally, we assume that all programmable resistors at the column under analysis are controlled identically so that they are using the maximum relative weight, pushing a maximal current to the column under analysis. Additionally, we inspect a rectangular ACIM core, i.e. $N_R$ = Nc. The target of this analysis is to find conditions under which the input digital-to-analog converter and the direct-drive analog-to-digital converter use their maximum dynamics, i.e. x=y.

The input digital-to-analog converter is modelled by its equivalent voltage source that sees the net parallel resistance of $N_C$ programmable resistors, i.e. $R_u$ / $N_C$. Consequently, the voltage level $v_r$ at the row under analysis is presented by the Equation 5 as:

$$v_r = \frac{\frac{R_u}{N_C}}{r_{ux} + \frac{R_u}{N_C}} \; v_x \; . \qquad\qquad (5)$$

where $r_{ux}$ is the unit resistance level of the input digital-to-analog converter.

The net current at the column under analysis is the sum current of $N_R$ programmable resistors and the opposing current of the direct-drive analog-to-digital converter's inherent digital-to-analog converter. The integrated iDAC of the ADC is modelled with its equivalent current source whose polarity readily takes account the inverted polarity of the iDAC. The unit resistance level of the inherent digital-to-analog converter analog-to-digital converter is $r_{uy}$.

The column under analysis must be biased to 0 V for to analog compute-in-memory to operate correctly and, consequently, the net current at the column must be zero. In the following analysis we can write:

$$N_R i_C - \frac{v_y}{r_{uy}} = 0$$

$$\Rightarrow v_y = N_R r_{uy} i_C$$

By inserting the output current $i_C$ from Equation 4 we can write:

$$\Rightarrow v_y = N_R r_{uy} \frac{\sum_{k=0}^{N_w-1} 2^k w_k}{2^{N_w}} \frac{v_r}{R_u}$$

By inserting the row voltage level $v_r$ from Equation 5 we can write:

$$\Rightarrow v_y = N_R r_{uy} \frac{\sum_{k=0}^{N_w-1} 2^k w_k}{2^{N_w}} \frac{\frac{R_u}{N_C}}{r_{ux} + \frac{R_u}{N_C}} \frac{v_x}{R_u}$$

By considering that the matrix is of rectangular shape, i.e. that $N_R$ = Nc, we can write:

$$\Rightarrow v_y = \frac{\sum_{k=0}^{N_w-1} 2^k w_k}{2^{N_w}} \frac{r_{uy}}{r_{ux} + \frac{R_u}{N_C}} v_x$$

By considering the maximum weight applied at the programmable resistors, and therefore considering that the expression $\frac{\sum_{k=0}^{N_w-1} 2^k w_k}{2^{N_w}}$ approaches 1, i.e. $\frac{\sum_{k=0}^{N_w-1} 2^k w_k}{2^{N_w}} \longrightarrow 1$ , we can write:

$$\Rightarrow v_y \approx \frac{r_{uy}}{r_{ux} + \frac{R_u}{N_C}} v_x$$

By considering an applied relative unit resistors sizing between the input DAC and the matrix, and therefore considering that the unit resistance $r_{ux} = \frac{R_u}{N_C}$ , we can write:

$$\Rightarrow v_y = \frac{1}{2} \frac{r_{uy}}{r_{ux}} v_x$$

The proposed relative sizing is possible to reach since $R_u$ is large, i.e. the resistivity level of the ACIM core is large. By inserting the output current $i_C$ from Equation 4 we can write:

$$\Rightarrow \frac{\sum_{k=0}^{N_y-1} 2^k y_k}{2^{N_y}} \frac{v_{ddy}}{r_{uy}} = \frac{1}{2} \frac{\sum_{k=0}^{N_x-1} 2^k x_k}{2^{N_x}} \frac{v_{ddx}}{r_{ux}}$$

where $N_y$ is the number of bits in the integrated direct-drive digital-to-analog converter of the analog-to-digital converter, where $y_k$ is a tuning bit for the inherent digital-to-analog converter, and where $v_{ddx}$ is the supply of the input digital-to-analog converter.

By considering that the input digital-to-analog converter and the inherent digital-to-analog converter have the same number of bits, i.e. $N_x = N_y$ and considering the target of having the same digital swing levels at the input digital-to-analog converter and the successive-approximation analog-to-digital converter, i.e. that $x_k = y_k$, we get the following result as Equation 6:

$$\Rightarrow \frac{v_{ddy}}{r_{uy}} = \frac{1}{2} \frac{v_{ddx}}{r_{ux}} \ . \tag{6}$$

Equation 6 shows that the output data value y for the signal path under analysis is directly proportional to the input data value x. Notably, $x_k = x_k$ when $r_{uy} = 2r_{ux}$. Equation 6 also shows that supply scaling can also be used for setting the output code of the successive-approximation analog-to-digital converter equal to the input code of the input digital-to-analog converter.

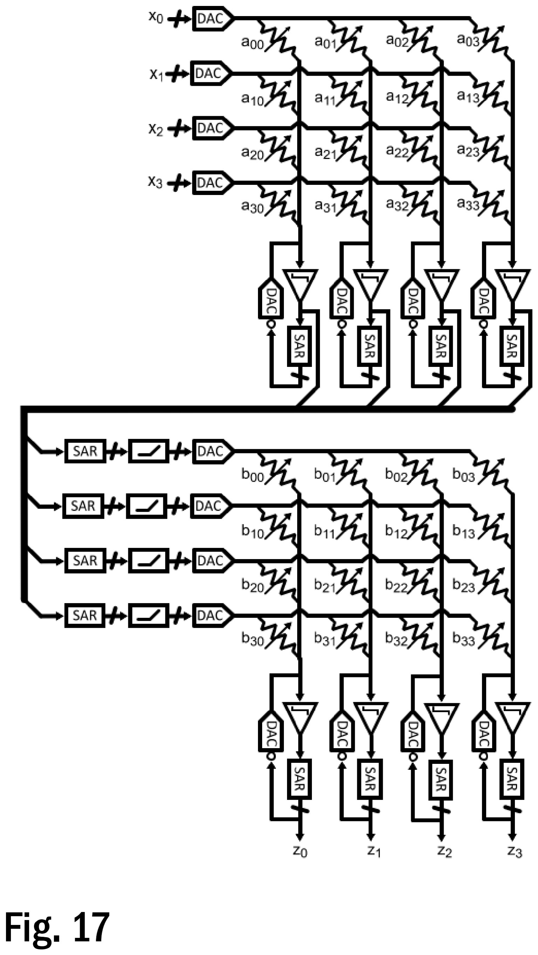

Figure 17 illustrates a third example of an extended ACIM core based on programmable resistive matrices. In Figure 17 an ACIM core based on programmable resistive matrices is extended with further propagation of the conversion results of a direct-drive successive-approximation analog-to-digital converters. Figure 17 depicts the propagation of an output of an analog compute-in-memory matrix core to the input of another ACIM core, with rectified linear unit activation function applied between the ACIM cores.

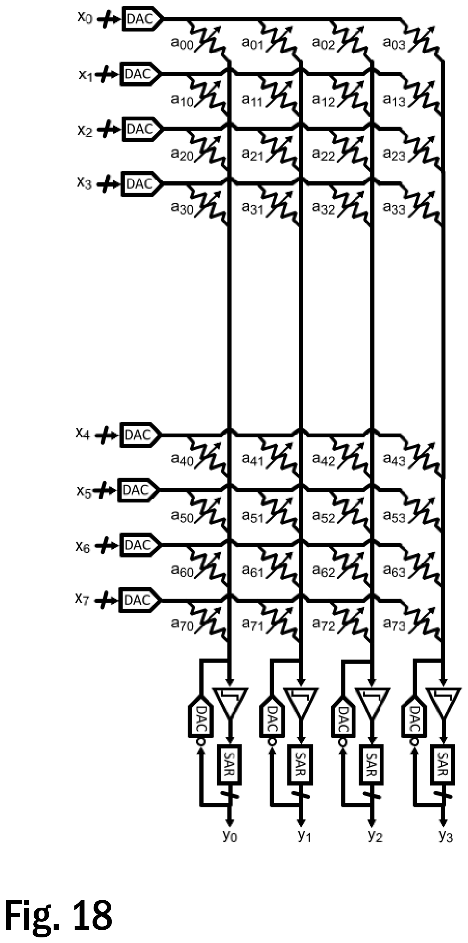

Figure 18 illustrates a fourth example of an extended ACIM core based on programmable resistive matrices. In Figure 18 two ACIM core based on programmable resistive matrices are combined to form a double input vector length ACIM core. Figure 18 depicts merging of one analog compute-in-memory matrix core into another ACIM core to realise one effective ACIM core with a double-length input vector.

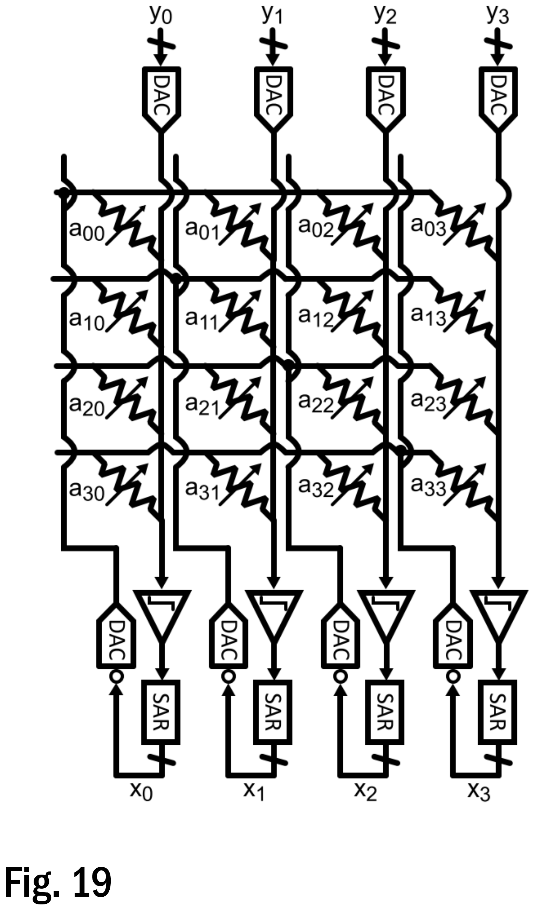

Figure 19 illustrates an example embodiment of a matrix inversion ACIM core based on programmable resistive matrices and direct-drive analog-to-digital converters. In an embodiment of Figure 19 of direct-drive technique is applied to an analog compute-in-memory matrix re-configuration that supports matrix inversion calculation. For instance, the inverse of Equation 1 can be computed deploying the configuration of Figure 19, this giving result as Equation 7:

$$x = A^{-1}y \ . \tag{7}$$

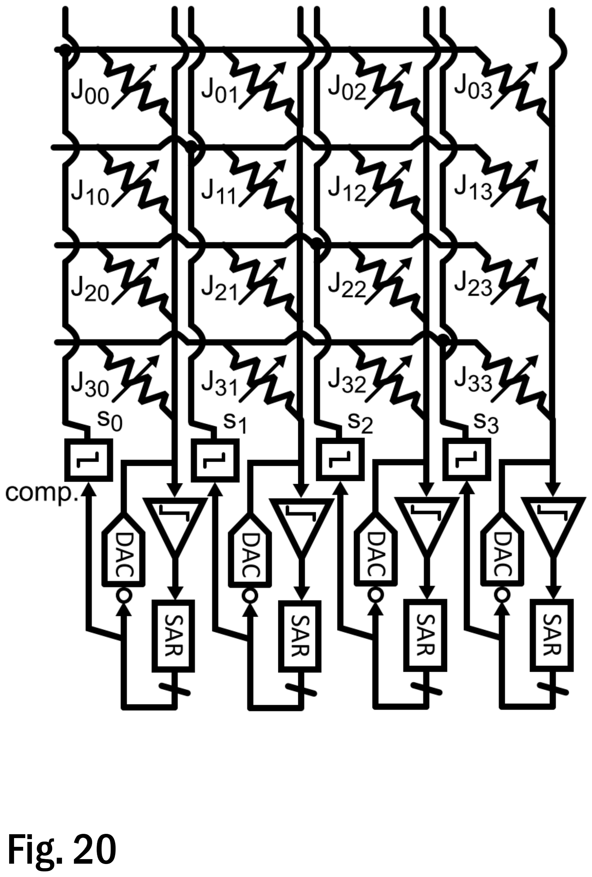

Figure 20 illustrates an example embodiment of an Ising machine ACIM core based on programmable resistive matrices and direct-drive analog-to-digital converters. In an embodiment of Figure 20 of direct-drive technique is applied to an analog compute-in-memory matrix re-configuration that supports Ising machine computation. For instance, the embodiment of Figure 20 realizes Ising machine that minimizes the Ising Hamiltonian $H_p$ in Equation 8 as:

$$H_P = \sum_{i,j=0}^{N-1} J_{ij} s_i s_j \ . \tag{8}$$

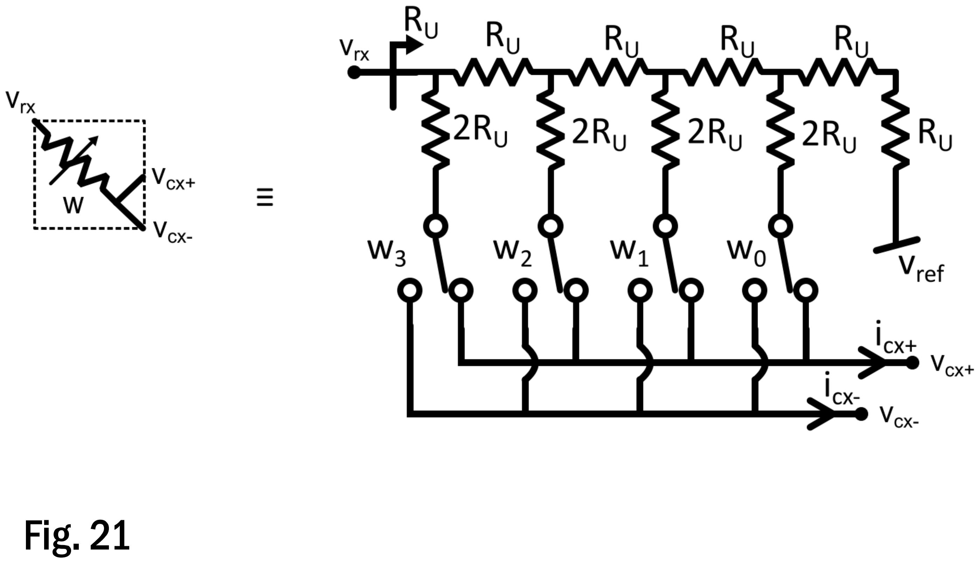

Figure 21 illustrates an example embodiment of a differential derivative for the single-ended weight unit of a 4-bit implementation for programmable resistors in an analog compute-in-memory matrix. Some applications may require negative weights for the vector-matrix multiplication, i.e. some of the elements in matrix A in Equation 1 should be negative.

In Figure 21 a 4-bit implementation for programmable resistors in an ACIM controlled by a tuning word w and comprising differential weight unit branches is shown in which each differential weight unit branch can be connected to one of two outputs. One of the outputs is connected to a column representing a positive signal (+) and the other output is connected to a column representing a negative signal (-). The corresponding net currents $i_{c+}$ and $i_c$- are presented in Equation 9 and in Equation 10 as:

$$i_{c+} = \frac{\sum_{k=0}^{N_w-1} 2^k w_k}{2^{N_w}} \frac{v_{rx}}{R_u} \tag{9}$$

$$i_{c-} = \frac{\sum_{k=0}^{N_w-1} 2^k (1-w_k)}{2^{N_w}} \frac{v_{rx}}{R_u} \qquad (10)$$

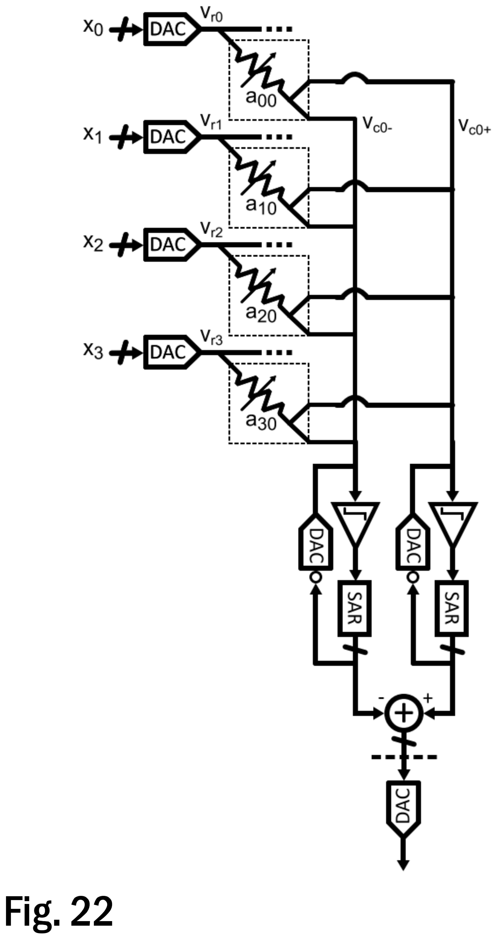

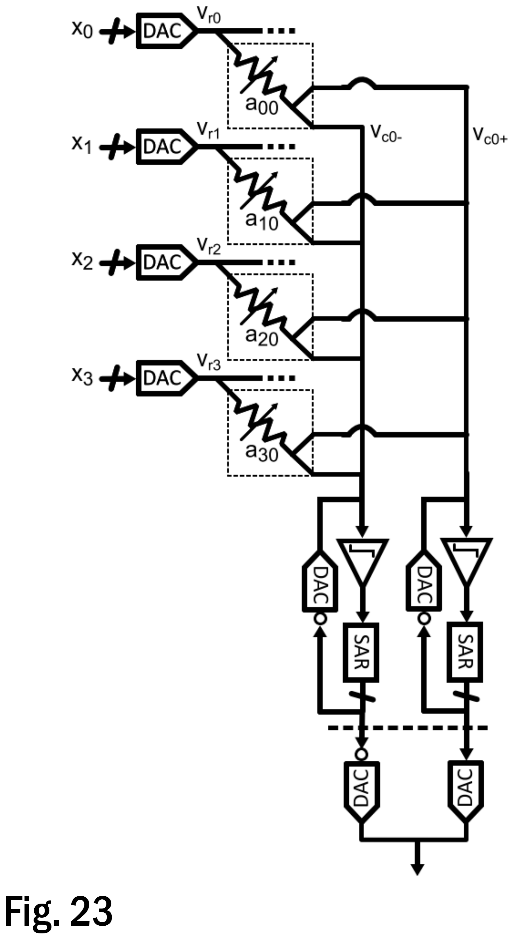

The net currents $i_{c+}$ and $i_{c-}$ presented in Equation 9 and in Equation 10 can be differentiated by two parallel direct-drive analog-to-digital converters, as shown in Figures 22 and 23. The differential current is given by Equation 11 as:

$$i_{c+} - i_{c-} = \frac{\sum_{k=0}^{N_w-1} 2^{k+1} (w_k - 0.5)}{2^{N_w}} \frac{v_{rx}}{R_u} \; . \qquad (11)$$

The Equation 11 shows that the differential current can gain a positive or negative value, depending on the applied weight, i.e. the net weight may have a positive or negative value, as targeted.

Figure 22 illustrates an example embodiment of a hardware implementation for a direct-drive ACIM core supporting negative weights. In Figure 22 only one matrix column is shown for clarity. In the example embodiment of Figure 22 a digital summer is used to extract the net signal represented by differential current $i_{c+}$-$i_{c-}$. As shown in Figure 22, the net currents $i_{c+}$ and $i_{c-}$ can be differentiated by two parallel direct-drive analog-to-digital converters. The dashed line marks a potentially long signal line or a potentially long data bus.

Figure 23 illustrates another example embodiment of a hardware implementation for a direct-drive ACIM core supporting negative weights. In Figure 23 only one matrix column is shown for clarity. In the example embodiment of Figure 23 analog summing at the output of sequential digital-to-analog converters is used to extract the net signal represented by differential current $i_{c+}$-$i_{c-}$. As shown in Figure 23, the net currents $i_{c+}$ and $i_{c-}$ can be differentiated by two parallel direct-drive analog-to-digital converters. In the propagation method of the example embodiment of Figure 23, at least one of said direct-drive successive approximation analog-to-digital converters is arranged to provide a logic block output signal to at least one other digital-to-analog converter. The dashed line marks a potentially long signal line or a potentially long data bus.

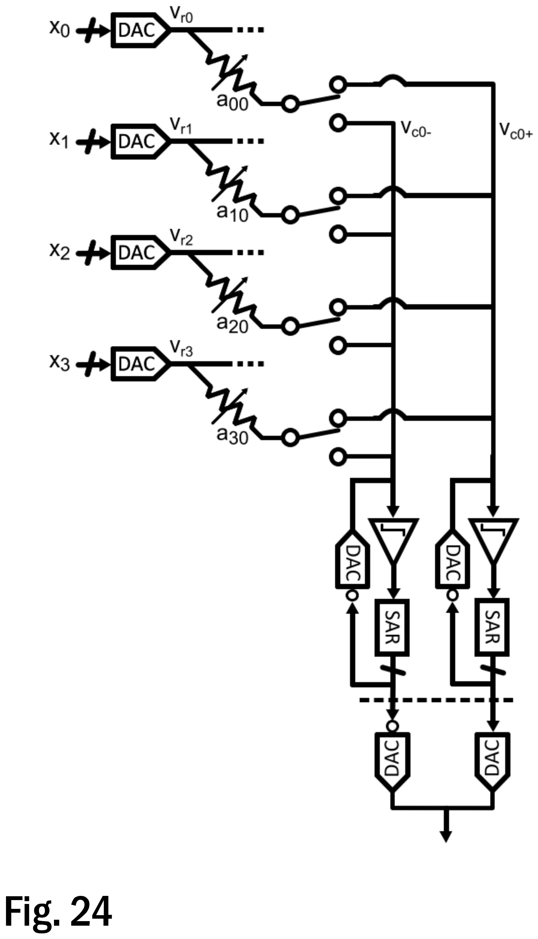

Figure 24 illustrates a third example embodiment of a hardware implementation for a direct-drive ACIM core supporting negative weights. In Figure 24 only one matrix column is shown for clarity. In the example embodiment of Figure 24 a single-ended weight unit and a serial switch are used for selecting whether the output current is pushed to the positive or negative signal column. The dashed line marks a potentially long signal line or a potentially long data bus.

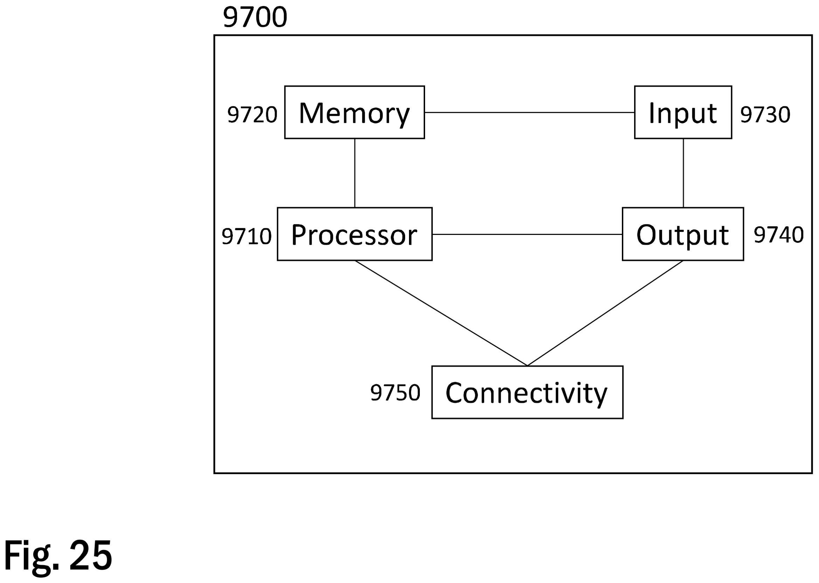

Figure 25 illustrates an example of an apparatus comprising means for performing one or more of the example embodiments described above. For example, the apparatus 9700 may be an apparatus such as, or comprising, or comprised in, a user equipment (UE) 100, 102. The user equipment may also be called a wireless communication device, a subscriber unit, a mobile station, a remote terminal, an access terminal, a user terminal, a terminal device, or a user device.

The apparatus 9700 may comprise a circuitry, a module or a chipset applicable for realizing one or more of the example embodiments described above. For example, the apparatus 9700 may comprise at least one processor 9710. The at least one processor 9710 interprets instructions (e.g., computer program instructions) and processes data. The at least one processor 9710 may comprise one or more programmable processors. The at least one processor 9710 may comprise programmable hardware with embedded firmware and may, alternatively or additionally, comprise one or more application-specific integrated circuits (ASICs).

The at least one processor 9710 is coupled to at least one memory 9720. The at least one processor is configured to read and write data to and from the at least one memory 9720. The at least one memory 9720 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The at least one memory 9720 stores computer readable instructions that are executed by the at least one processor 9710 to perform one or more of the example embodiments described above. For example, non-volatile memory stores the computer readable instructions, and the at least one processor 9710 executes the instructions using volatile memory for temporary storage of data and/or instructions. The computer readable instructions may refer to computer program code.

The computer readable instructions may have been pre-stored to the at least one memory 9720 or, alternatively or additionally, they may be received, by the apparatus, via an electromagnetic carrier signal and/or may be copied from a physical entity such as a computer program product. Execution of the computer readable instructions by the at least one processor 9710 causes the apparatus 9700 to perform one or more of the example embodiments described above. That is, the at least one processor and the at least one memory storing the instructions may provide the means for providing or causing the performance of any of the methods and/or blocks described above.

In the context of this document, a "memory" or "computer-readable media" or "computer-readable medium" may be any non-transitory media or medium or means that can contain, store, communicate, propagate or transport the instructions for use by or in connection with an instruction execution system, apparatus, or device, such as a computer. The term "non-transitory," as used herein, is a limitation of the medium itself (i.e., tangible, not a signal) as opposed to a limitation on data storage persistency (e.g., RAM vs. ROM).

The apparatus 9700 may further comprise, or be connected to, an input unit 9730. The input unit 9730 may comprise one or more interfaces for receiving input. The one or more interfaces may comprise for example one or more temperature, motion and/or orientation sensors, one or more cameras, one or more accelerometers, one or more microphones, one or more buttons and/or one or more touch detection units. Further, the input unit 9730 may comprise an interface to which external devices may connect to.

The apparatus 9700 may also comprise an output unit 9740. The output unit may comprise or be connected to one or more displays capable of rendering visual content, such as a light emitting diode (LED) display, a liquid crystal display (LCD) and/or a liquid crystal on silicon (LCoS) display. The output unit 9740 may further comprise one or more audio outputs. The one or more audio outputs may be for example loudspeakers.

The apparatus 9700 further comprises a connectivity unit 9750. The connectivity unit 9750 enables wireless connectivity to one or more external devices. The connectivity unit 9750 comprises at least one transmitter and at least one receiver that may be integrated to the apparatus 9700 or that the apparatus 9700 may be connected to. The at least one transmitter comprises at least one transmission antenna, and the at least one receiver comprises at least one receiving antenna. The connectivity unit 9750 may comprise an integrated circuit or a set of integrated circuits that provide the wireless communication capability for the apparatus 9700. Alternatively, the wireless connectivity may be a hardwired application-specific integrated circuit (ASIC). The connectivity unit 9750 may also provide means for performing at least some of the blocks or functions of one or more example embodiments described above. The connectivity unit 9750 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

It is to be noted that the apparatus 9700 may further comprise various components not illustrated in Figure 25. The various components may be hardware components and/or software components.

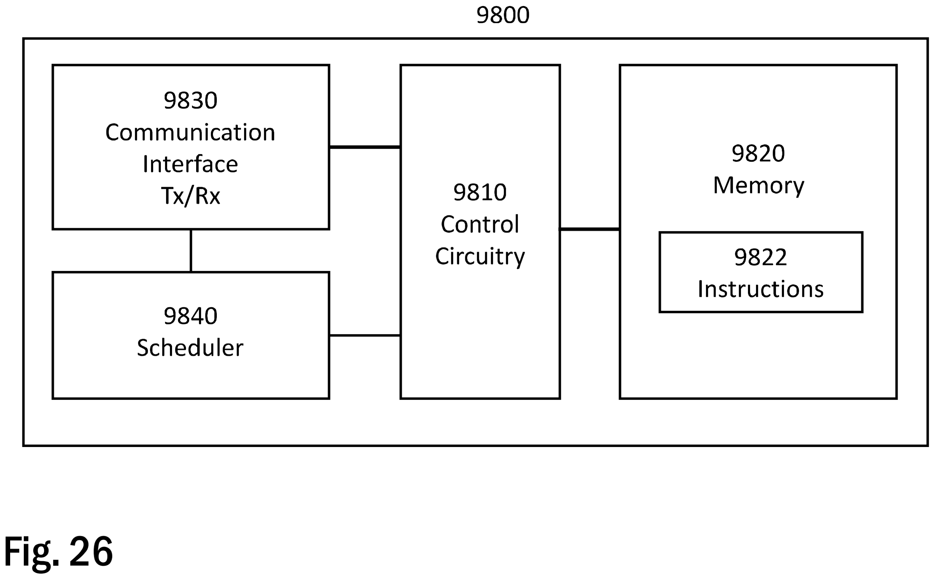

Figure 26 illustrates an example of an apparatus 9800 comprising means for performing one or more of the example embodiments described above. For example, the apparatus 9800 may be an apparatus such as, or comprising, or comprised in, an access node 104 of a radio access network.

The apparatus 9800 may comprise, for example, a circuitry, a module or a chipset applicable for realizing one or more of the example embodiments described above. The apparatus 9800 may be an electronic device comprising one or more electronic circuitries. The apparatus 9800 may comprise a communication control circuitry 9810 such as at least one processor, and at least one memory 9820 storing instructions 9822 which, when executed by the at least one processor, cause the apparatus 9800 to carry out one or more of the example embodiments described above. Such instructions 9822 may, for example, include computer program code (software). The at least one processor and the at least one memory storing the instructions may provide the means for providing or causing the performance of any of the methods and/or blocks described above.

The processor is coupled to the memory 9820. The processor is configured to read and write data to and from the memory 9820. The memory 9820 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The memory 9820 stores computer readable instructions that are executed by the processor. For example, non-volatile memory stores the computer readable instructions, and the processor executes the instructions using volatile memory for temporary storage of data and/or instructions.

The computer readable instructions may have been pre-stored to the memory 9820 or, alternatively or additionally, they may be received, by the apparatus, via an electromagnetic carrier signal and/or may be copied from a physical entity such as a computer program product. Execution of the computer readable instructions causes the apparatus 9800 to perform one or more of the functionalities described above.

The memory 9820 may be implemented using any suitable data storage technology, such as semiconductor-based memory devices, flash memory, magnetic memory devices and systems, optical memory devices and systems, fixed memory and/or removable memory. The memory may comprise a configuration database for storing configuration data, such as a current neighbour cell list, and, in some example embodiments, structures of frames used in the detected neighbour cells.

The apparatus 9800 may further comprise or be connected to a communication interface 9830, such as a radio unit, comprising hardware and/or software for realizing communication connectivity with one or more wireless communication devices according to one or more communication protocols. The communication interface 9830 comprises at least one transmitter (Tx) and at least one receiver (Rx) that may be integrated to the apparatus 9800 or that the apparatus 9800 may be connected to. The communication interface 9830 may provide means for performing some of the blocks and/or functions (e.g., transmitting and receiving) for one or more example embodiments described above. The communication interface 9830 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

The communication interface 9830 provides the apparatus with radio communication capabilities to communicate in the wireless communication network. The communication interface may, for example, provide a radio interface to one or more UEs 100, 102. The apparatus 9800 may further comprise or be connected to another interface towards a core network 110, such as the network coordinator apparatus or AMF, and/or to the access nodes 104 of the wireless communication network.

The apparatus 9800 may further comprise a scheduler 9840 that is configured to allocate radio resources. The scheduler 9840 may be configured along with the communication control circuitry 9810 or it may be separately configured.

It is to be noted that the apparatus 9800 may further comprise various components not illustrated in Figure 26. The various components may be hardware components and/or software components.

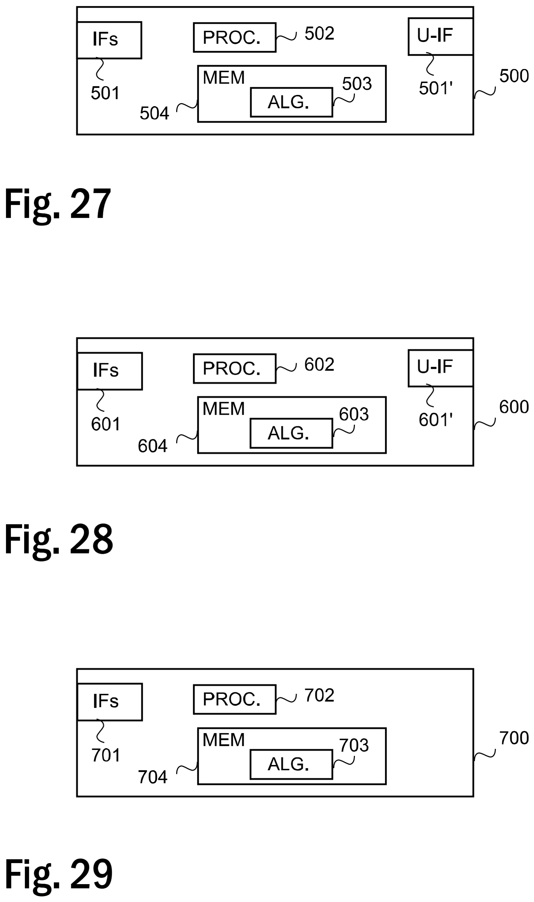

Figure 27 illustrates an example of an apparatus according to some embodiments of the present invention in connection with the user apparatus/user device. Figure 27 illustrates an apparatus configured to carry out the functions described above in connection with the user apparatus/user device. Each apparatus 500 may comprise one or more communication control circuitry, such as at least one processor 502, and at least one memory 504, including one or more algorithms 503, such as a computer program code (software) wherein the at least one memory and the computer program code (software) are configured, with the at least one processor, to cause the apparatus to carry out any one of the exemplified functionalities of the user apparatus. The apparatus may further comprise different communication interfaces 501 and one or more user interfaces 501'.

Referring to Figure 27, at least one of the communication control circuitries in the apparatus 500 is configured to carry out application-specific computational solutions, to perform computing matrix operations, such as vector-matrix multiplications, to implement machine-learning accelerators as stand-alone or jointly with other accelerators such as digital compute-in-memory, or to carry out functionalities, described above by means of Figures 1 to 24, by one or more circuitries.

Figure 28 illustrates an example of an apparatus according to some embodiments of the present invention in connection with the node element. Figure 28 illustrates an apparatus configured to carry out the functions described above in connection with the node element. Each apparatus 600 may comprise one or more communication control circuitry, such as at least one processor 602, and at least one memory 604, including one or more algorithms 603, such as a computer program code (software) wherein the at least one memory and the computer program code (software) are configured, with the at least one processor, to cause the apparatus to carry out any one of the exemplified functionalities of the node element. The apparatus may further comprise different communication interfaces 601 and one or more user interfaces 601'.

Referring to Figure 28, at least one of the communication control circuitries in the apparatus 600 is configured to carry out application-specific computational solutions, to perform computing matrix operations, such as vector-matrix multiplications, to implement machine-learning accelerators as stand-alone or jointly with other accelerators such as digital compute-in-memory, or to carry out functionalities, described above by means of Figures 1 to 24, by one or more circuitries.

Figure 29 illustrates an example of an apparatus according to some embodiments of the present invention in connection with the base station. Figure 29 illustrates an apparatus configured to carry out the functions described above in connection with the base station. Each apparatus 700 may comprise one or more communication control circuitry, such as at least one processor 702, and at least one memory 704, including one or more algorithms 703, such as a computer program code (software) wherein the at least one memory and the computer program code (software) are configured, with the at least one processor, to cause the apparatus to carry out any one of the exemplified functionalities of the base station. The memory 704 may comprise a database for storing different information, for example contact information on apparatuses, and information needed for maintenance. The apparatus may further comprise different communication interfaces 701.

Referring to Figure 29, at least one of the communication control circuitries in the apparatus 700 is configured to carry out application-specific computational solutions, to perform computing matrix operations, such as vector-matrix multiplications, to implement machine-learning accelerators as stand-alone or jointly with other accelerators such as digital compute-in-memory, or to carry out functionalities, described above by means of Figures 1 to 24, by one or more circuitries.

The apparatus may be an any electronic device of any kind, such as, and not limited to, user equipments and other electronic devices that may require such a memory apparatus. The apparatus may may be any electrical device connectable to an access network and configurable to be in a wireless connection on one or more communication channels, including one or more control channels, with an access network component, e.g. an access network apparatus, providing a cell, for example. The physical link from the apparatus to the access network towards a core network is called an uplink or a reverse link and the physical link to the apparatus is called a downlink or a forward link. By way of example rather than limitation, the apparatus may referred to as a served apparatus, a downlink apparatus, a mobile apparatus, a terminal device, a communication device, a user equipment (UE), a subscriber station (SS), a portable subscriber station, a mobile station (MS), or an access terminal (AT). A non-limiting lists of examples of the apparatus, or what the apparatus may comprise or be comprised in, include a mobile phone, a cellular phone, a smart phone, a voice over internet protocol (VoIP) phone, a wireless local loop phone, a device using a wireless modem, a portable computer, a desktop computer, laptop-embedded equipment (LEE), laptop-mounted equipment (LME), a smart device, a multimedia device, an image capture terminal device, such as a digital camera, a gaming terminal device, a music storage and playback appliance, a drone, a vehicle, an automated guided vehicle, an autonomous connected vehicle, a vehicle-mounted wireless terminal device, a wireless endpoint, an internet of things device, an industrial internet of things device, a device operating in an industrial and/or an automated processing chain contexts, a consumer electronics device, a consumer internet of things device, a mobile robot, a mobile robot arm, a sensor, a surveillance camera, an eHealth related device, a medical monitoring device, a medical device, for example for remote surgery, a wearable device, such as a smart watch, a smart ring, a head-mounted display (HMD), an on-person device, etc. The apparatus may also be part of a group of apparatuses seen as one apparatus, i.e. one mobile apparatus, by the wireless network.

The apparatus may be any access network component of an access network. An access network domain may be based on any kind of an access network, such as a cellular access network, for example 5G network, 5G-Advanced network, 6G network, etc., a non-terrestrial network, a legacy cellular radio access network, for example 4G or older generation network, or a non-cellular access network, for example a wireless local area network, or any combination thereof. To provide the wireless access, the access network comprises access network components, such as access network apparatuses, or access devices. An access device component may provide one or more cells, possibly with different cell accessibility per a cell, but a cell is provided by one access device. However, there may be overlapping cells, for example a macro cell provided by an access device operating in co-operation of access nodes providing smaller cells, such as micro-, femto- or picocells, which overlap at least partly within the macro cell. There are a wide variety of access network components. A non-limiting lists of examples of the access network component, include different types of base stations, such as eNBs, gNBs, split gNBs, transmission-reception points, network-controlled repeaters, nodes operationally coupled to one or more remote radio heads, satellites, donor nodes in integrated access and backhaul (IAB), fixed IAB nodes, mobile IAB nodes mounted on vehicles, for example, etc. At least some of the apparatuses in the access network may provide an abstraction platform to separate abstractions of network functions from the processing hardware.

Further, it should be noted that some of the components may be multi-domain components. For example a device component may also provide services to other device components, i.e. operate also as an access network component, for example be a relay node, or a mobile IAB node, or a mobile termination part in an IAB node. Hence, herein term mobile apparatus is used for device components, or device component functionality in a multi-domain component and term access network apparatus is used for access network components or access network component functionality in a multi-domain component.

Replacing the conventional resistive ACIM approach based on buffer amplifiers with the direct-drive approach comes with several benefits. Firstly, there are potential area, power and speed benefits. Secondly, the direct-drive approach eliminates various drawbacks of analog amplifiers, including limited output voltage range, added noise, and limited linearity. Thirdly, direct-drive ADCs are much less sensitive to their feedback network than direct-drive amplifiers, making it easier for an ACIM core to support various extensions and operation modes. Some signal processing operators such as ReLUs, comparators and memory are much easier to implement in the digital domain (supported by the direct-drive approach) than analog domain (supported by the conventional approach). Finally, the proposed direct-drive method supports also negative weights.

ACIM accelerators can be used for machine learning and advanced computing in mobile network base stations. However, machine learning accelerators are a widely applicable outside mobile networks as well. ACIM accelerators may be implemented on an integrated circuit.

As used in this application, the term "resistive memory" may refer to one or more or all of the following: resistive memory may be the same (resistive/memory) element, i.e. the memory element itself acts simultaneously as a resistor, resistive memory may comprise e.g. one or more of the following: Memristors, FeFET, RRAM, MRAM, OxRAM, CNTRAM.

As used in this application, the term "memory element" may refer to one or more or all of the following: memory element may comprise e.g. SRAM, DRAM, non-volatile flash or a memory based e.g. on RRAM.

As used in this application, the term "resistive element" may refer to one or more or all of the following: resistive element may comprise e.g. a resistor, a memristor, a switch-controlled resistor, a switch-controlled resistor of a R2R network, or a varactor.

As used in this application, the term "activation function" may refer to one or more or all of the following: activation function may comprise e.g. a linear activation function, a rectified linear unit, ReLU, a binary step, a Heaviside activation function, a logistic activation function (etc. here listing a number of relevant activation functions) or any other type of generally known activation function.

As used in this application, the term "circuitry" may refer to one or more or all of the following: a) hardware-only circuit implementations (such as implementations in only analog and/or digital circuitry); and b) combinations of hardware circuits and software, such as (as applicable): i) a combination of analog and/or digital hardware circuit(s) with software/firmware and ii) any portions of hardware processor(s) with software (including digital signal processor(s), software, and memory(ies) that work together to cause an apparatus, such as a mobile phone, to perform various functions); and c) hardware circuit(s) and/or processor(s), such as a microprocessor(s) or a portion of a microprocessor(s), that requires software (for example firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

The techniques and methods described herein may be implemented by various means. For example, these techniques may be implemented in hardware (one or more devices), firmware (one or more devices), software (one or more modules), or combinations thereof. For a hardware implementation, the apparatus(es) of example embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (for example procedures, functions, and so on) that perform the functions described herein. The software codes may be stored in a memory unit and executed by processors. The memory unit may be implemented within the processor or externally to the processor. In the latter case, it can be communicatively coupled to the processor via various means, as is known in the art. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

It will be obvious to a person skilled in the art that, as technology advances, the inventive concept may be implemented in various ways within the scope of the claims. The embodiments are not limited to the example embodiments described above, but may vary within the scope of the claims. Therefore, all words and expressions should be interpreted broadly, and they are intended to illustrate, not to restrict, the embodiments.

**Claims**

1. An apparatus comprising: at least one processor; and at least one memory storing instructions that, when executed by the at least one processor, cause the apparatus at least to:

   provide an analog signal to at least one input of an analog compute-in-memory resistive matrix comprised in said apparatus;
   receive a digital signal from at least one direct-drive analog-to-digital converter in the output of said at least one analog compute-in-memory resistive matrix,
   wherein said at least one direct-drive analog-to-digital converter is a direct-drive successive approximation analog-to-digital converter, and
   wherein said at least one direct-drive successive approximation analog-to-digital converter has a self-biasing circuitry comprising a comparator in the input of said direct-drive successive approximation analog-to-digital converter, said comparator arranged to compare a reference node voltage to an input node voltage from an output of an inherent digital-to-analog converter said inherent digital-to-analog converter receiving as an input signal the output signal of said direct-drive successive approximation analog-to-digital converter with inverted polarity.

2. The apparatus according to claim 1, wherein said provided analog signal is converted from a digital signal by at least one direct-drive digital-to-analog converter in the input of said at least one analog compute-in-memory resistive matrix.

3. The apparatus according to claim 1 or to claim 2, wherein said at least one analog compute-in-memory resistive matrix is realised with at least one resistive memory comprising at least one resistive element within said at least one resistive memory.

4. The apparatus according to claim 1 or to claim 2, wherein said at least one analog compute-in-memory resistive matrix is realised with at least one memory element and at least one resistive element.

5. The apparatus according to claim 1, wherein said at least one direct-drive successive approximation analog-to-digital converter is arranged to provide an output signal of said comparator to at least one other digital-to-analog converter via a synchronised successive approximation logic of said at least one direct-drive successive approximation analog-to-digital converter.

6. The apparatus according to claim 1, wherein said at least one direct-drive successive approximation analog-to-digital converter is arranged to provide a logic block output signal to at least one other digital-to-analog converter.

7. The apparatus according to claim 1, wherein said at least one direct-drive successive approximation analog-to-digital converter is arranged to provide said output signal of an inherent digital-to-analog converter to at least one load.

8. The apparatus according to any of the claims 5-7, comprising an activation function between the output of said synchronised successive approximation logic and the input of said inherent digital-to-analog converter or between the output of said synchronised successive approximation logic and the input of said at least one other digital-to-analog converter.

9. The apparatus according to any of the claims 1-4, wherein a digital output from at least one direct-drive analog-to-digital converter in the output of a first analog compute-in-memory resistive matrix is connected to a digital input to at least one direct-drive digital-to-analog converter in the input of a second analog compute-in-memory resistive matrix.

10. The apparatus according to any of the claims 1-4, wherein the output columns of a first analog compute-in-memory resistive matrix and the output columns of a second analog compute-in-memory resistive matrix are combined and connected to said at least one direct-drive analog-to-digital converter in the output of said second analog compute-in-memory resistive matrix.

11. The apparatus according to claim 1, wherein said output of an inherent digital-to-analog converter of said at least one direct-drive successive approximation analog-to-digital converter is connected back to the input rows of said at least one analog compute-in-memory resistive matrix for a matrix inverse calculation.

12. The apparatus according to claim 1, wherein said output of an inherent digital-to-analog converter of said at least one direct-drive successive approximation analog-to-digital converter is connected back to the input rows of said at least one analog compute-in-memory resistive matrix via at least one comparator for an Ising machine calculation.

13. The apparatus according to any preceding claim, wherein said at least one analog compute-in-memory resistive matrix is realised with at least one resistive memory comprising at least one programmable resistor within said at least one resistive memory.

14. The apparatus according to any preceding claim, wherein the apparatus is an electronic device, a user apparatus, a user device, a node element, a base station, an access network component, a served apparatus, a downlink apparatus, a mobile apparatus, a terminal device, a communication device, a user equipment, a subscriber station, a portable subscriber station, a mobile station, or an access terminal.

15. The apparatus according to any of claims 1 to 13, wherein the apparatus comprises a circuitry, a module or a chipset.

# Fig. 1

Fig. 2

Fig. 3

in_a

comp.

SAR

out_d

DAC

ref_a

Fig. 4

**Fig. 5**

EP 4 733 981 A1

Fig. 6

Fig. 7

Fig. 8

Fig. 9

EP 4 733 981 A1

Fig. 10

EP 4 733 981 A1

Fig. 11

EP 4 733 981 A1

in_d[N-1:0] —/→ 1
                    ReLU
0 —/→ 0
         S                    —/→ out_d[N-1:0]

in_d[N-1]

# Fig. 12A

1 —/→ 1
            Comparator
-1 —/→ 0
          S                   —/→ out_d[N-1:0]

in_d[N-1]

# Fig. 12B

Fig. 13

Fig. 14

Fig. 15

EP 4 733 981 A1

## Fig. 16A

## Fig. 16B

Fig. 17

Fig. 18

Fig. 19

Fig. 20

Fig. 21

EP 4 733 981 A1

Fig. 22

Fig. 23

Fig. 24

9700

| 9720 | Memory | | Input | 9730 |

| 9710 | Processor | | Output | 9740 |

| 9750 | Connectivity |

**Fig. 25**

EP 4 733 981 A1

Fig. 26

9800

9830
Communication
Interface
Tx/Rx

9840
Scheduler

9810
Control
Circuitry

9820
Memory

9822
Instructions

EP 4 733 981 A1

**Fig. 27**

**Fig. 28**

**Fig. 29**

Europäisches
Patentamt

European
Patent Office

Office européen
des brevets

## EUROPEAN SEARCH REPORT

**Application Number**

EP 25 21 0318

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | QIU KENI ET AL: "ResiRCA: A Resilient Energy Harvesting ReRAM Crossbar-Based Accelerator for Intelligent Embedded Processors", 2020 IEEE INTERNATIONAL SYMPOSIUM ON HIGH PERFORMANCE COMPUTER ARCHITECTURE (HPCA), IEEE, 22 February 2020 (2020-02-22), pages 315-327, XP033755291, DOI: 10.1109/HPCA47549.2020.00034 [retrieved on 2020-04-13] * figures 3, 5 * | 1-15 | INV.<br>G06G7/16<br>H03M1/46<br><br>ADD.<br>G06N7/01<br>G06G7/18<br>G06N3/048<br>G06N3/063 |

TECHNICAL FIELDS
SEARCHED (IPC)

G06G
G06N
H03M

The present search report has been drawn up for all claims

| Place of search | Date of completion of the search | Examiner |
|---|---|---|
| The Hague | 18 February 2026 | Theissing, Simon |

EPO FORM 1503 03.82 (P04C01)